# EUROPEAN PATENT SPECIFICATION

(11) **EP 2 132 782 B1**
(45) Date of publication and mention of the grant of the patent: **11.07.2012**
(21) Application number: 07701493.4
(22) Date of filing: 15.02.2007
(51) Int. Cl.: H01L 31/0352, H01L 31/042, H01L 31/05

(54) **A SUBSTRATE ASSEMBLY, AN ASSEMBLY PROCESS, AND AN ASSEMBLY APPARATUS**
SUBSTRATASSEMBLY, ASSEMBLY-VERFAHREN UND ASSEMBLY-APPARAT
ASSEMBLAGE DE SUBSTRATS, PROCÉDÉ D'ASSEMBLAGE ET APPAREIL D'ASSEMBLAGE

(43) Date of publication of application: 16.12.2009
(73) Proprietor: Transform Solar Pty Ltd., Sydney, NSW 2000 (AU)
(72) Inventor: EVERETT, Vernie, Allan, Kaleen, ACT 2617 (AU); BLAKERS, Andrew, William, Aranda, ACT 2614 (AU)
(74) Representative: Frost, Alex John
(86) International application number: PCT/AU2007/000162
(87) International publication number: WO 2008/098279

(56) References cited:
- WO-A1-02/45143
- WO-A1-2004/100252
- WO-A1-2006/015430
- WO-A1-2006/015430
- WO-A1-2006/133507
- DE-C- 3 807 031
- DE-C1- 19 711 319
- JP-A- 06 140 651
- JP-A- 2004 047 838
- US-A- 4 163 194
- US-A- 4 652 693
- US-A1- 2001 040 453
- SCHEIBENSTOCK S ET AL: "Progress in monolithic series connection of wafer-based crystalline silicon solar cells by the novel 'HighVo' (High Voltage) cell concept" SOLAR ENERGY MATERIALS AND SOLAR CELLS, ELSEVIER SCIENCE PUBLISHERS, AMSTERDAM, NL LNKD- DOI:10.1016/S0927-0248(00)00093-3, vol. 65, no. 1-4, 1 January 2001 (2001-01-01), pages 179-184, XP004217117 ISSN: 0927-0248
- DATABASE WPI Week 200453, Derwent Publications Ltd., London, GB; Class A85, AN 2004-550404, XP008139059 & NL 1 021 591 C2 (ENERGIEONDERZOEK CENT PETTEN ECN) 06 April 2004
- DATABASE WPI Week 200453, Derwent Publications Ltd., London, GB; Class A85, AN 2004-550403, XP008139060 & NL 1 021 582 C2 (STICHTING ENERGIEONDERZOEK CENT NED) 06 April 2004

## Description

### Field

The present invention relates to a substrate assembly, an assembly process, and an assembly apparatus, and in particular to an assembly of electrically interconnected elongate semiconductor substrates for a photovoltaic device, and a process and apparatus for forming the assembly.

### Background

In this specification, the terms "elongate substrate" and "elongate solar cell" respectively refer to a substrate or solar cell of generally parallelepiped form and having a high aspect ratio in that its length is substantially greater (typically some tens to hundreds of times larger) than its width. Additionally, the thickness of an elongate substrate or solar cell is typically four to one hundred times smaller than its width. The length and width of an elongate solar cell are the dimensions of the active "face" or "faces" of the solar cell and therefore together define the maximum available active surface area for power generation, whereas the length and thickness of a solar cell are the dimensions of the optically inactive surfaces or "edges" of a cell, and the width and thickness of a solar cell are the dimensions of the optically inactive surfaces or "ends" of a cell. A typical elongate solar cell is 10-120 mm long, 0.5-5 mm wide, and 15-400 microns thick.

Elongate substrates and solar cells can be produced by processes such as those described in "HighVo (High Voltage) Cell Concept" by S. Scheibenstock, S. Keller, P. Fath, G. Willeke and E. Bucher, Solar Energy Materials & Solar Cells Vol. 65 (2001), pages 179-184 ("Scheibenstock"), and in International Patent Application Publication No. WO 02/45143 ("the Sliver® patent application"). The latter document describes processes for producing a large number of thin (generally < 150 µm) elongate silicon substrates from a single standard silicon wafer such that their total usable surface area is greater than that of the original silicon wafer. Elongate substrates formed by the processes described in the sliver patent application are referred to herein as 'sliver substrates', whereas elongate substrates formed by any other process are referred to herein as 'plank substrates'. The Sliver® patent application also describes processes for forming solar cells on sliver substrates, with the resulting processed substrates also being referred to as 'sliver solar cells'. However, in this specification the word 'sliver' generally refers to a sliver substrate which may or may not incorporate one or more solar cells. The word "sliver" is a registered trade mark of Origin Energy Solar Pty Ltd, Australian Registration No. 933476.

In general, elongate solar cells can be single-crystal solar cells or multi-crystalline solar cells formed on elongate substrates using essentially any solar cell manufacturing process. The elongate substrates are preferably formed in a batch process by forming a series of parallel elongate openings or slots through a silicon wafer to define a corresponding series of parallel elongate substrates, joined together by the remaining peripheral portions of the wafer, referred to collectively as the wafer frame.

Solar cells can be formed on the elongate substrates while they remain joined together by the wafer frame, and subsequently separated from each other and the wafer frame to provide a set of individual elongate solar cells. The elongate slices of silicon in which elongate solar cells are formed are fragile and need careful handling, in particular during separation from the wafer frame but also during subsequent processing. Additionally, since the area and value of each elongate cell is small when compared with a large-area conventional (i. e., non-elongate, wafer-scale) solar cell, solar cell modules incorporating elongate cells require a significantly larger number of individual cells per module (e.g., up to the order of a hundred or more times as many cells). There is therefore a need for reliable, low cost handling, assembly, and mounting processes in order to make the use of the elongate substrates and solar cells economically viable.

Existing approaches to using elongate solar cells to form photovoltaic devices have been limited in scope. One of the difficulties encountered is the need for precise placement and precise electrical interconnection of a relatively large number of elongate cells over a relatively large area.

Conventional solar cell modules, particularly modules incorporating entire monocrystalline or multi-crystalline silicon wafers, typically contain around 60 to 70 mono-facial (i.e., providing only one active surface for power generation) wafer cells per square metre of module area. The number of electrical connections in such a module is of the order of 200, or around 4 per cell.

In contrast, the number of electrical connections per elongate solar cell may be only slightly higher at around six or eight per cell, but because the area of each elongate cell is only a small fraction of the area of a conventional cell, the number of electrical connections in a solar cell module incorporating elongate solar cells may be in the range of 2,000 to 20,000 or more per square metre of module area. It is evident from this consideration alone that a non-conventional approach is desired in order to cheaply and reliably establish the electrical interconnections in solar cell modules incorporating elongate solar cells.

One application of solar cells is in so-called linear concentrator systems. An example of such a system is a trough concentrator, which includes long, large-area sun-tracking rows of mirrors or refractive lenses which concentrate sunlight on high efficiency small-area solar cells. A typical linear photovoltaic concentrator system operates at a geometric solar illumination concentration ratio in the range of about 8 to 80 times that of a "one-sun" system (referred to as 8-80 "suns"). In such an arrangement, a single line of conventional concentrator solar cells is mounted on the receiver. A conventional concentrator solar cell is of the order of 2 cm to 5 cm wide, and 4 cm to 8 cm long. In a linear receiver, 20 to 40 cells are connected in series along the length of the receiver which has a typical length of 1-2 m. The uniformity of the light is generally quite good along the length of the receiver but can be poor in the transverse direction, typically with an approximately Gaussian-like intensity profile. The solar cells are usually connected in series along the receiver to provide a higher overall output voltage.

In a typical linear concentrator system, electrical current is conducted from the centre of each cell on its upper and lower surfaces to four contacts on the upper and lower surfaces of the two outer edges of the cell. Electrical connection is made to each of these contacts to remove the current. Series connection of the solar cells is achieved at the edge of the receiver by an appropriate interconnection technique, typically involving the use of sheet copper tabs. However, the series interconnection with this conventional system occupies a significant area, making this method unsuitable for wide receivers, or receiver systems where multiple rows of adjoining concentrator solar cells are required. Additionally, electrical current flow along the length of a conventional linear concentrator receiver is a process of moving electrical charge transversely from the central region of each cell to its edge, into the external connections or copper tabs to the copper tabs in the adjoining cell, and thence back into the central region of the neighbouring cell. As a consequence, significant series resistance losses arise, primarily because of the greatly extended effective current path.

WO-A-2006/133507 describes a solar cell interconnection process for elongate solar cells. The elongate cells are mounted on a crossbeam support structure to maintain solder in position.

It is desired to provide a substrate assembly for a photovoltaic device, an assembly process, and an assembly apparatus that alleviate one or more of the above difficulties, or at least provide a useful alternative.

### Summary

In accordance with the present invention, there is provided a substrate assembly for a photovoltaic device, the assembly including an array of elongate semiconductor substrates, each of the elongate substrates having opposite faces bounded by longitudinal edges, the elongate substrates being electrically interconnected and maintained in a longitudinally parallel arrangement by an electrically conductive material disposed between the opposing longitudinal edges of adjacent ones of said elongate substrates such that the opposite faces of each elongate substrate remain entirely exposed between the electrically conductive material.

In this specification, the term "elongate substrate", and "elongate solar cell" are often used interchangeably. In general, the present invention relates to particular forms of arranging and interconnecting elongate substrates to form an assembly for a photovoltaic device, and processes for forming those forms of assembly. In general, the elongate substrates of an assembly may or may not incorporate solar cells. If they do not yet incorporate solar cells, then those solar cells will need to be formed in the elongate substrates after forming the assembly so that the assembly can be used to generate power. Although in many places throughout this specification only one of the terms "elongate substrate" and "elongate solar cells" might be used in a particular part of the description, it will be apparent to those skilled in the art that in many instances it does not matter whether the solar cells have already been formed, or are yet to be formed, and the description should be understood accordingly. In other places, the skilled addressee will understand from the context that the substrates will already have functioning solar cells formed therein and can thus be considered to be elongate solar cells.

Additionally, the assemblies of elongate substrates described herein are also often referred to as "sub-modules". This is because, in most applications (excluding specialised applications such as mini-modules, for example), many such assemblies will be required to be electrically interconnected to provide a solar power module that provides a level of power desired for most applications. Conventional power modules are constructed by interconnecting a large number of conventional, wafer-scale solar cells together, and it is particularly advantageous that the elongate substrate assemblies described herein can have similar lateral dimensions to the diameter of a conventional wafer-scale solar cell, as this allows existing handling and processing equipment and methods to be used, either as-is, or with only minor modifications. Similarly, where functioning solar cells have not yet been formed in the elongate substrates, the assembly is sometimes also referred to herein as a "pre-module". However, although the number and configuration of elongate substrates is preferably such that the resulting assembly is accurately referred to as a sub-module (or pre-module), it will also be apparent that the number and configuration of elongate substrates could be such that the resulting assembly could form a solar power module or mini-module in its own right. The use of the words "sub-module" and "pre-module" should therefore not in general be construed as limiting the form of the assemblies in any way.

WO-A-2006/133507 ("the solder process patent application"), describes a particularly advantageous solder process for forming electrical interconnections in modules incorporating elongate solar cells. That and WO-A-2006/015430 ("the rafts patent application"), provide details for the electrical interconnection of sub-module assemblies where the elongate solar cells are spaced apart at some uniform array spacing, or are assembled in a continuous array on a suitable substrate. The processes described in those patent applications provide useful sub-module assemblies for static concentrator solar power modules, flexible modules, and mini-modules. However, preferred embodiments of the present invention provide other structures of interest, including high efficiency bi-facial solar power modules constructed from a continuous or semi-continuous assembly of purely bifacial sub-module assemblies, full coverage high-efficiency mono-facial solar power modules, full coverage high-efficiency flexible solar power modules, and high efficiency mono-facial concentrator receiver modules constructed from a continuous or semi-continuous assembly of sub-module assemblies.

Preferred embodiments of the invention also include a process and apparatus for assembling fully bifacial elongate solar cell sub-module assemblies. These fully bifacial sub-module assemblies are referred to generically as elongate solar cell sub-assembly sheets, or more simply as sliver sheets or plank sheets. These sheet sub-assemblies are particularly attractive for high efficiency solar power modules in general, and high efficiency bifacial solar power modules in particular.

In conventional photovoltaic modules, the cells, bus bar and cell connections are entirely encapsulated within a matrix of elastic material such as ethylene vinyl acetate (EVA), which is itself sandwiched between a glass substrate and a protective back-sheet or another glass sheet. For various reasons, with prior art (referred herein as "first generation") elongate solar cell assembly technology, it is not convenient to entirely encapsulate the elongate solar cells in a manner similar to conventional solar power modules. Rather, because of the handling limitations of the first generation assembly process, it has been necessary to bond elongate cells directly to a supporting substrate, most commonly glass. However, this arrangement makes it difficult to form reliable electrical connections between elongate cells.

The rafts patent application describes various forms of solar cell sub-module assemblies incorporating elongate solar cells, including forms referred to respectively as 'rafts', 'mesh rafts', and 'boats'. The solder process described in the solder process patent application solved the problem of electrical interconnections for spaced arrays of elongate solar cells forming rafts, where the electrical interconnections were placed on the physical supporting structure of the sub-assembly; mesh rafts, where the electrical interconnections actually formed the physical supporting structure; and boats, where the electrical interconnections were formed on or in the physical supporting substrate. Preferred embodiments of the invention described herein include methods for forming elongate solar cell sub-module assemblies, where the electrical interconnection also forms the physical supporting structure of the sub-module assembly, but in such a manner as to avoid shading or partial shading of one or both surfaces, and eliminating the requirement for appreciable spacing between adjacent elongate solar cells in the structure, such as is the case with the rafts and mesh raft sub-modules described in the rafts patent application, or the introduction of any further sections or pieces of electrical conductor such as is the case with the mesh raft sub-modules described in the rafts patent application.

The assemblies and processes described herein have particular application to solar power modules, which typically use non-concentrated sunlight, and which usually comprise 30-50 conventional silicon solar cells connected electrically together in series and encapsulated behind glass. However, in the case of solar power modules incorporating elongate solar cells, the conventional silicon solar cells are replaced with elongate solar cell sub-module assemblies referred to as sliver sheets or plank sheets which are the functional equivalent of high-voltage, low-current conventional solar cells. Similarly, in the case of concentrator receiver modules incorporating elongate solar cells, the conventional silicon concentrator solar cells are replaced with elongate solar cell concentrator sub-module assemblies referred to as sliver concentrator sheets or plank concentrator sheets which are the functional equivalent of high-voltage, low-current conventional concentrator solar cells.

The assemblies and processes described herein also have particular application to linear concentrator receivers, which utilise concentrated sunlight, and which typically comprise 20-40 silicon concentrator solar cells connected together electrically and mounted on a suitable heat sink at the focus of a solar linear concentrating system, but in the case of linear concentrator receivers incorporating elongate solar cells, the conventional silicon concentrator solar cells are replaced with elongate solar cell concentrator sub-module assemblies referred to as sliver concentrator sheets or plank concentrator sheets which are the functional equivalent of high voltage, low current conventional silicon concentrator solar cells.

The close spacing between adjacent elongate solar cells in the sub-module assembly can be finely tuned according to electrical materials and assembly requirements. In some embodiments, there are essentially no spacings, so that the edges of adjacent elongate solar cells effectively abut. In other embodiments, the spacings between each elongate solar cell are sufficiently wide to allow a conductive paste or solder paste to be stencilled or screen-printed or introduced into the gap between the opposing edges of two adjacent elongate substrates by a method such as stamp printing, pump printing, jet printing, or to allow the introduction of a conductive liquid such as molten solder either by wave soldering, capillary action in a solder bath, immersing in molten solder and removing the excess by mechanical spinning under heat or by the action of a hot air knife. Details of these processes, which can be directly transferred from similar methods on related structures, or slightly modified to suit the structures described herein, are provided in the solder process patent application. The electrically conductive material which also establishes the mechanical support in the sub-module assembly and the electrical interconnections between the elongate solar cells, can be in the form of continuous, semi-continuous, or intermittent electrically conducting sections along the direction of the electrode tracks. The intermittent sections act as stress relief in a direction along the length of the elongate solar cells. The magnitude of the stress induced by differential expansion between the cell and the conductive material is modulated by the width and thickness of the conductive material relative to the thickness of the elongate solar cell and the respective material moduli. Furthermore, the plane of action, and hence the localised torsion induced in the sub-assembly from the action of stress induced by the differential expansion of each element of the electrical connection array can be modulated by the location, length, spacing, cross-sectional area and cross-sectional profile, and distributed quantity of the electrically conductive material above and or below the central plane of the sliver sheet or plank sheet sub-module. These factors provide a multi-parameter optimisation space for controlling the physical behaviour of the multi-elongate solar cell array with respect to controlling internal stresses, controlling internal elemental torsion from induced stress, and providing a robust, durable, easily handled and processed physical structure.

The sheet assemblies or sub-modules formed by the bonding of adjacent or abutting elongate substrates or solar cells, and in particular the respective electrodes of adjacent or adjoining or abutting elongate solar cell electrodes or electrode metallisation sections, solely via electrically conductive material such as metallo-organic inks, metallo-organic pastes, metal-composite resins, metal-composite polymers, metal-composite elastomers, metal-composite silicones, or metallic alloys such as tin-lead solder, tin-lead-silver solder, lead free solder, or preferably a eutectic lead free solder that provides the dual role of electrical connectivity and physical support for the collective assembly of elongate solar cells in the sub-module, referred to in this specification as "elongate substrate sheets", "elongate solar cell sheets", or generically as "sheets", or more particularly as "sliver sheets" or "plank sheets", can include a few to several hundred elongate substrates or solar cells.

Another advantage of the elongate solar cell sheets and concentrator sheets described herein is the ease of measurement of the efficiency of the sub-module assembly. The measurement of the efficiency of a large number of individual small solar cells can be inconvenient, time-consuming, and expensive. However, a method and a process for efficient and cheap testing, sorting and binning into performance categories is described below. Alternatively, in order to minimise handling for high- and uniform-yield elongate solar cell production, the elongate solar cell sheets and concentrator sheets described herein allow the efficiency of the elongate solar cell sheets and concentrator sheets to be directly measured after assembly, rather than measuring individual cells before assembly, thus effectively allowing dozens to hundreds of small solar cells to be measured together in a single operation. This approach reduces measurement cost and time so that it becomes viable to sort the elongate solar cell sheets and concentrator sheets into categories of performance (including a fail category), and then select from the sorted elongate solar cell sheets and concentrator sheets to assemble solar power modules, concentrator receivers, or mini-modules with different performance characteristics. Those elongate solar cell sheets and concentrator sheets whose performance is below a minimum level can be discarded or divided into sub-sections and remeasured. If the individual elongate solar cells that cause the poor performance are primarily in one portion of the elongate solar cell sheets and concentrator sheets, then some subsections may have good performance while another section might need to be discarded because its performance is not sufficiently good.

Particular processes for assembling a plurality of elongate solar cells into sub-module assemblies or arrays of cells depend principally on the structure and format of the elongate cells, the orientation and arrangement of the cells in the parent wafer, and the structure and format of the planar array of the elongate cells in the finished sub-module assembly. However, the structure and function, the motivation and purpose, and the benefits and utility of the sub-module assemblies described above do not reside in the process of formation, but rather in the physical, optical, electrical, and utilitarian properties of these assemblies of elongate solar cells forming the elongate solar cell sheets and concentrator sheet sub-module assemblies described herein. The elongate solar cell sheets and concentrator sheets sub-module assemblies make possible the convenient, fast, low cost, and reliable handling, manipulation and testing and binning, and final assembly into high areal efficiency sub-module assemblies of large numbers of elongate solar cells in a minimal sequence of highly efficient, modular operations.

The ability to fabricate stand-alone, self-contained elongate solar cell "sheets" and "concentrator sheets" greatly simplifies the separation, handling, and assembly of all forms of elongate solar cells and the construction of high efficiency PV modules containing these elongate solar cells. The assembly of elongate solar cell sheets and concentrator sheets can be accomplished with small, low cost devices, jigs, and machines that eliminate the requirements for large-scale accuracy and automation such as the devices and machines presently in use or presently considered to be necessary for some forms of elongate solar cell module assembly.

Furthermore, the tasks required for the assembly of solar power modules and concentrator receivers, such as stringing into rows and encapsulating the elongate solar cell sheet and concentrator sheet sub-module assemblies, can be performed with only slightly modified conventional PV cell stringing, interconnecting, cell handling, and cell assembly, and module encapsulation equipment.

An additional advantageous feature of the sub-module assemblies described herein is that solar power modules constructed using sub-modules assembled from elongate solar cells can be manufactured using entirely conventional photovoltaic (PV) module materials. The elongate solar cell sub-module assemblies, and the separation, handling, testing, binning, and assembly of these sub-assemblies into solar power modules, can be achieved by incorporating only the following material contributions to the module: elongate solar cells, solder and conventional bus-bars, EVA encapsulant, glass, and Tedlar module backing or equivalent material. In the case of bifacial high-efficiency, or high areal efficiency solar power modules constructed from bifacial elongate solar cells, the solar power module incorporating sheet sub-module assemblies is preferably constructed solely from the conventional materials of the elongate silicon solar cells, solder, conventional bus-bars, EVA encapsulant, and the front and rear - generally symmetrical - cover glass. In some light-weight, or shock-resistant applications, transparent acrylic, polycarbonate, or even PET or similar materials can be substituted for the front and or rear module cover glass.

The assemblies and processes described herein provide an opportunity and a means to eliminate the use, and also the requirements for the use, of adhesives of all forms - including optical adhesives and electrically conductive adhesives, conductive epoxies or conductive polymers or non-conventional solar power module conductive compounds of all forms including inks, pastes, and elastomers, and optical adhesives of all forms. Not only do the sub-module assemblies and processes described herein provide this opportunity and means of eliminating the use, and the requirement for the use of such materials, thus greatly enhancing the long-term reliability of the elongate solar cell module, but the processes so described also eliminate the requirement for stencilling or dispensing the solder paste for solder reflow which would otherwise be necessary for forming the solder joints that provide electrical interconnections between the elongate solar cells, and which also provide the physical and mechanical support between adjacent elongate solar cells forming the integrated sub-module assembly supporting structure. An additional advantage accompanying the elimination of solder paste is the reduction in solder flux needed for establishing the electrical interconnections, and hence the after-cleaning and level of chemical contamination and residues remaining on the device components.

As described above, a 'sliver' substrate is one that has been produced by the process described in the sliver patent application, whereby a series of parallel elongate openings or slots are opened through the entire thickness of a standard silicon wafer to produce a corresponding series of elongate pieces of silicon, such that the resulting useable surface area formed by the newly created surfaces perpendicular to the original wafer surface is greater than the surface area of the original wafer. However, elongate substrates can also be formed by other processes, in particular by a broadly similar process whereby a series of parallel openings or slots are formed through the wafer also to produce a corresponding series of parallel elongate substrates, but where the active surfaces or faces of those substrates are provided by the corresponding portions of the original wafer surface, rather than by the newly created surfaces perpendicular to the original wafer surface, as is the case with slivers. Elongate substrates formed by this alternative process are referred to herein as 'plank' substrates. Although plank substrates do not provide the increased surface area advantage provided by slivers, they nonetheless can provide substantial advantages over conventional, wafer-scale solar cells, as described below. The width of the planks is determined by the spacing of the machined grooves and the length of the planks is typically five to twenty times larger than the plank width. The thickness of the plank is the wafer thickness, which is usually less than 400 microns. Elongate solar cells and elongate substrates in the form of planks can be separated, handled, and assembled into sheet sub-module assemblies using the methods described in the rafts patent application.

Elongate plank solar cells are preferably formed from large area rear-contact solar cells. A particular form of elongate solar cell constructed from rear contact cell is suitable for use in low-to-moderate solar concentration linear concentrator receivers. A particular form of sheet sub-module assemblies described herein, constructed from elongate plank solar cells formed from commercially available rear-contact, high-efficiency, conventional flat-plate solar cells and assembled into concentrator sheet sub-module assemblies have been constructed. These prototype concentrator sheets have measured aperture efficiencies greater than 16% at a solar flux concentration of 20 (20 "Suns") with cell costs a small fraction of the cost of purpose-manufactured concentrator cells, measured in dollars per watt-peak output rating.

### Brief description of the drawings

Preferred embodiments of the present invention are hereinafter described, by way of example only, with reference to the accompanying drawings, wherein:

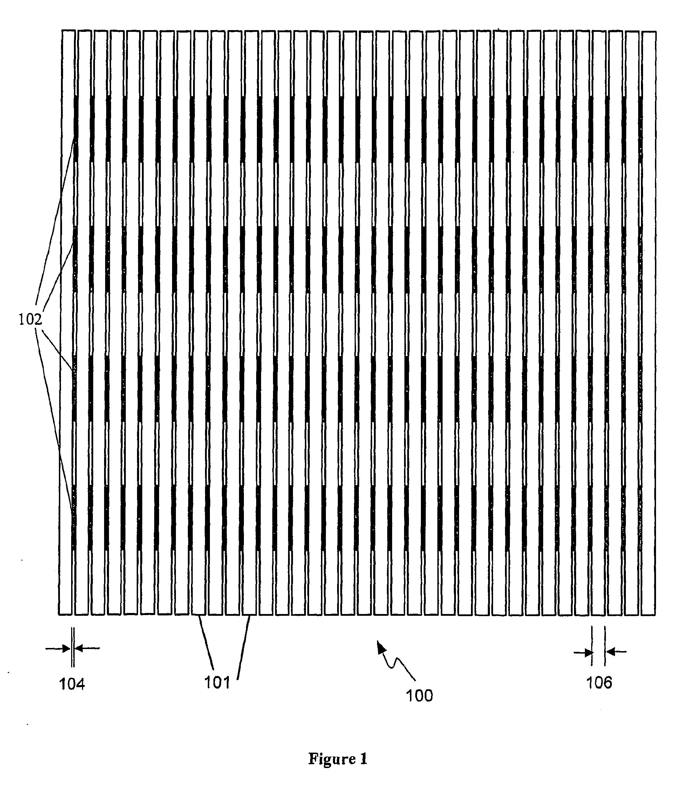

Figure 1 is a schematic plan view of a preferred embodiment of an elongate substrate assembly, being either an elongate solar cell sub-module formed from elongate solar cells, or elongate pre-module formed from elongate substrates, and referred to as a "sheet" sub-module or "sheet" pre-module respectively;

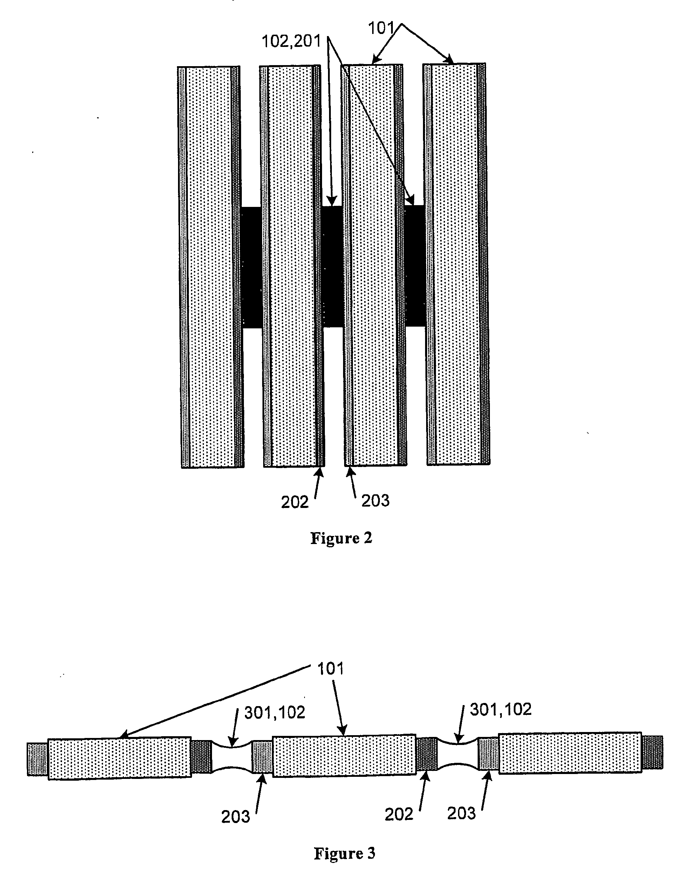

Figure 2 is a schematic plan view of part of the sheet shown in Figure 1 showing one form of electrical interconnection between the elongate solar cells in a sheet sub-module, or elongate substrates in a sheet pre-module;
Figure 3 is a cross-sectional view of a preferred embodiment of an elongate solar cell sub-module referred to as a "sheet" sub-module, or an elongate substrate pre-module referred to as a "sheet" pre-module, showing details of a second form of electrical interconnection between elongate solar cells or elongate substrates in sheet sub-modules or sheet pre-modules respectively;

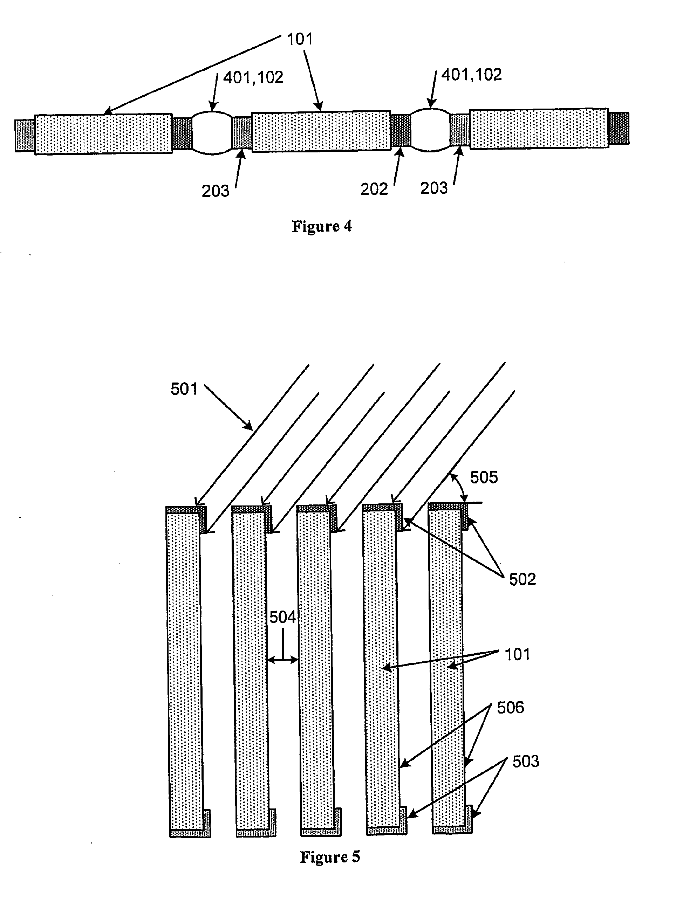

Figure 4 is a schematic cross-sectional view similar to Figure 3 of a preferred embodiment of an elongate solar cell sub-module referred to as a "sheet" sub-module, or an elongate substrate pre-module referred to as a "sheet" pre-module, showing details of yet another form of electrical interconnection between elongate solar cells or elongate substrates in sheet sub-modules or sheet pre-modules respectively;
Figure 5 is a schematic cross-sectional end view of an elongate solar cell array, or an elongate substrate array, illustrating the use of angled evaporation to partially coat faces of elongate solar cells to provide electrical contact surfaces on both an optically-inactive edge and an adjacent optically active face of each elongate solar cell or elongate substrate respectively;

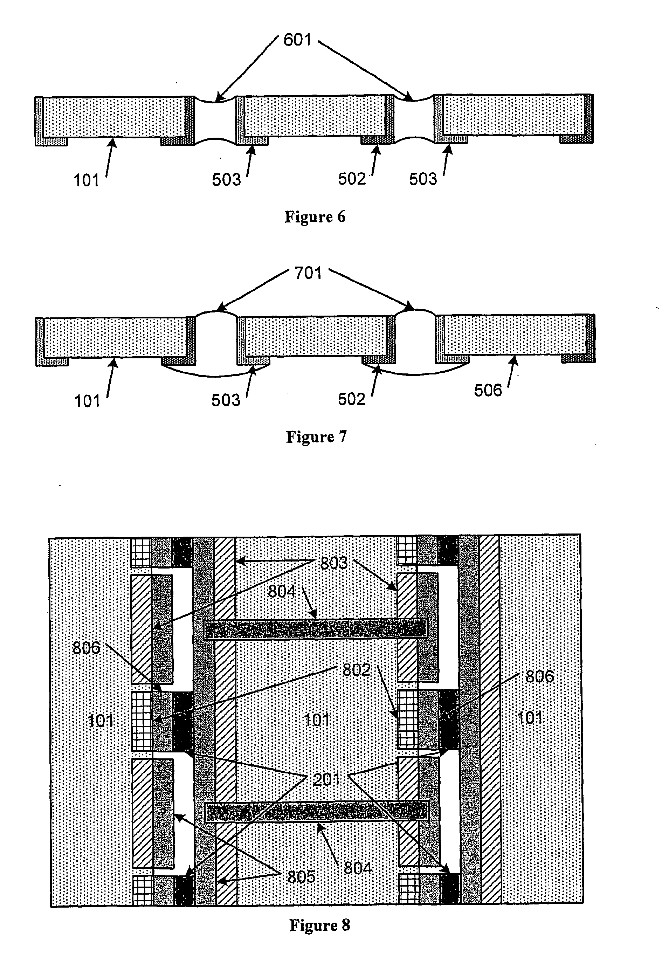

Figure 6 is a schematic end view of an elongate solar cell sheet sub-module showing one form or method of electrically interconnecting the elongate solar cells with electrical contacts on optically active faces and optically inactive edges. The same or similar method can be used to electrically interconnect elongate substrates in sheet pre-module assemblies;
Figure 7 is an end view of an elongate solar cell sheet sub-module showing a second form of electrically interconnecting the elongate solar cells with electrical contacts on optically active faces and optically inactive edges. This method is suitable for controlling curvature or warping of elongate solar cell sheets. The same method can be used to electrically interconnect elongate substrates and control warping in sheet pre-module assemblies;
Figure 8 is a plan view of part of a third preferred embodiment of a solar cell sub-module referred to as a "parallel-connected elongate solar cell sheet" sub-module or a "parallel-connected elongate substrate sheet" pre-module comprising only elongate solar cells or elongate substrates respectively, and parallel and serial electrical interconnections therebetween;

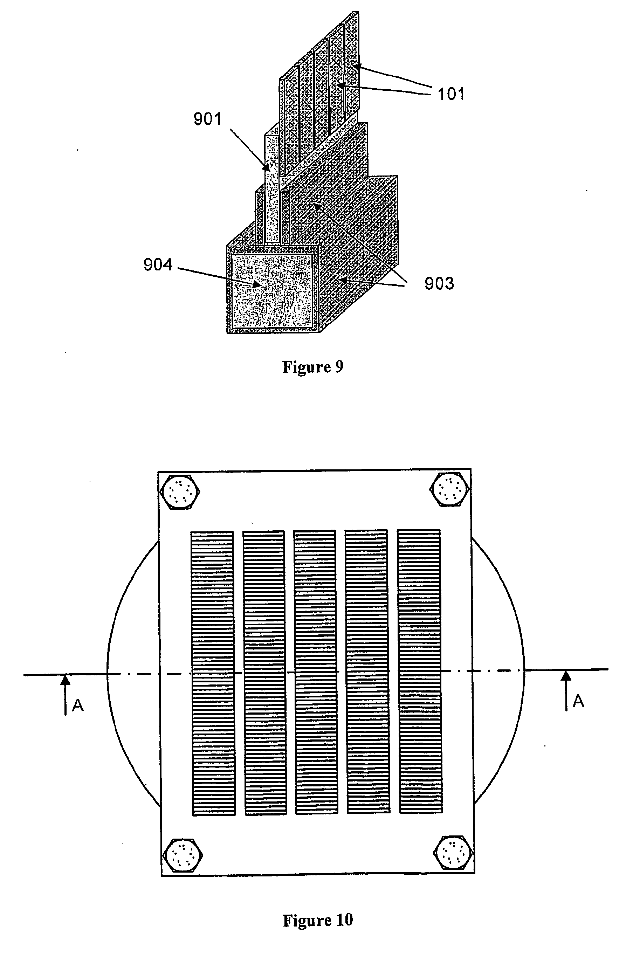

Figure 9 is a diagram showing how elongate solar cell sheets can be mounted onto a heat-sink substrate in a tooth-like formation. This method is particularly suitable for mounting bifacial elongate concentrator solar cell sheets into bifacial receiver assemblies;
Figure 10 is a schematic diagram of a simple one-piece clamp arrangement for a single device window such as shown in Figure 10. Similar clamps with a corresponding number of opposing and matching sections related to the extent and orientation of the device window and device direction can be constructed to serve the same purpose as this single-section clamp;

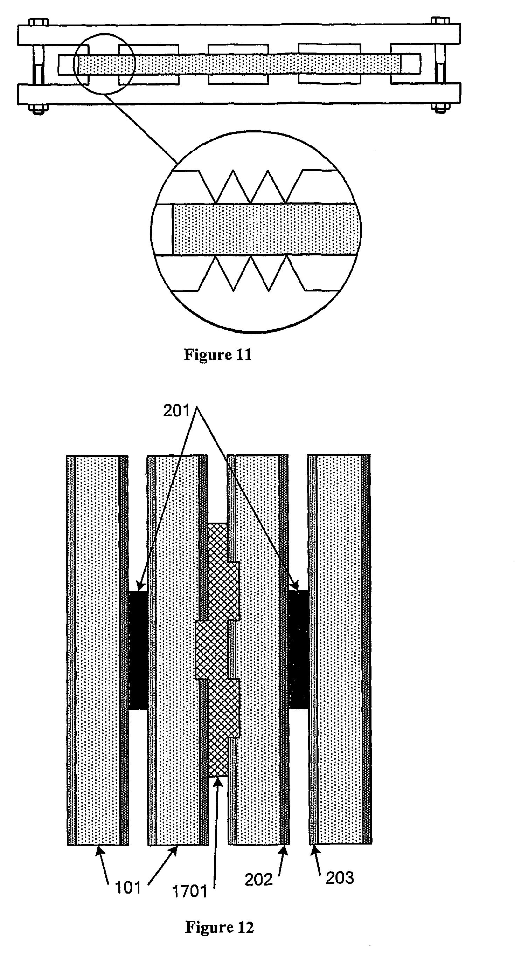

Figure 11 is a schematic diagram of the cross-section of a simple one-piece clamp arrangement for a single device window such as shown in Figure 10. The contact-retaining sections, running transverse to the direction of the elongate cells or elongate substrates contain semi-compliant ridged surfaces to minimise contact area and fluid flow restriction through and maximise fluid transfer between and under the contact area and the grooves during micro-machining. Similar clamps with a corresponding number of opposing and matching sections related to the extent and orientation of the device window and device direction can be constructed to serve the same purpose as this single-section clamp;
Figure 12 is a schematic plan view of a sheet-to-sheet electrical interconnection clip. The top surface and the bottom surface of the clip extend over and under the electrode and a small part of the surface of the elongate solar cell or elongate substrate at the ends of the sheets being electrically joined together. The tabs at the top and bottom surfaces serve to locate and retain the two adjoining sheet surfaces, and the section of fingers extending along the direction of the electrode server to draw solder by capillary action to the ends of the fingers, providing a secure joint;

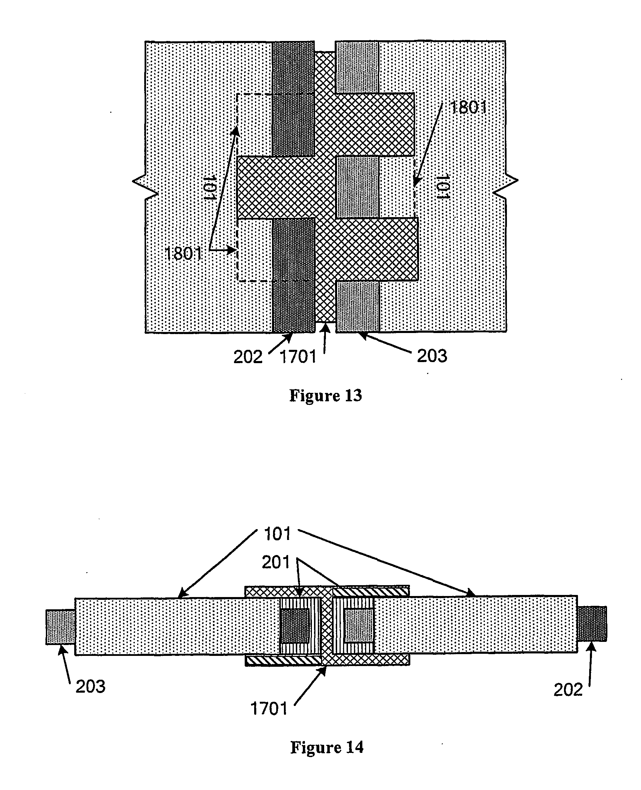

Figure 13 is a detailed schematic plan view of the sheet-to-sheet electrical interconnection clip shown in Figure 12. The top surface and the bottom surface of the clip extend over and under the electrode and a small part of the surface of the elongate solar cell or elongate substrate at the ends of the sheets being electrically joined together. The dotted lines show the complementary extent of the tabs at the bottom surfaces of adj oining sheets;
Figure 14 is a schematic cross-sectional view of a sheet-to-sheet electrical interconnection clip. The top surface and the bottom surface of the clip extend over and under the electrode and a small part of the surface of the elongate solar cell or elongate substrate at the ends of the sheets being electrically joined together. The tabs at the top and bottom surfaces serve to locate and retain the two adjoining sheet surfaces, and the section of fingers extending along the direction of the electrode, parallel to and in line with the central vertical section of the clip serve to draw solder by capillary action to the ends of the fingers, providing a secure joint. The solder is shown filling the cavity between the electrode and the inner surfaces of the clip;

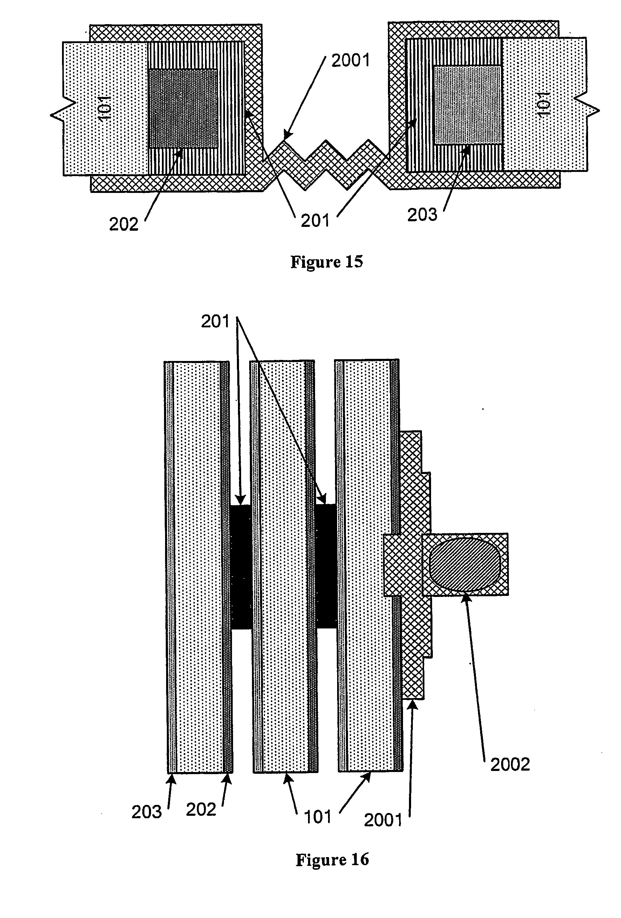

Figure 15 is a schematic cross-sectional view of a sheet-to-sheet electrical interconnection clip incorporating a stress relief corrugated section between the two electrode guide contact surfaces of the clip. The top surface and the bottom surface of the clip extend over and under the electrode and a small part of the surface of the elongate solar cell or elongate substrate at the ends of the sheets being electrically joined together as for the simple version in Figure 14. The tabs at the top and bottom surfaces serve to locate and retain the two adjoining sheet surfaces, and the section of fingers extending along the direction of the electrode, parallel to and in line with the central vertical section of the clip serve to draw solder by capillary action to the ends of the fingers, providing a secure joint. The solder is shown filling the cavity between the electrode and the inner surfaces of the clip;
Figure 16 is a schematic plan view of a sheet-to-bus bar electrical interconnection clip. The top surface and the bottom surface of the clip on the side of the last sheet in a string extend over and under the electrode and a small part of the surface of the elongate solar cell or elongate substrate at the end of the sheet, while on the opposite side of the clip a foot extends out, shown here pre-tinned with a solder pad, for accepting electrical connection to a bus-bar. The tabs at the top and bottom surfaces serve to locate and retain the two adjoining surfaces, and the section of fingers extending along the direction of the electrode server to draw solder by capillary action to the ends of the fingers, providing a secure joint to the remote sheet electrode surface;

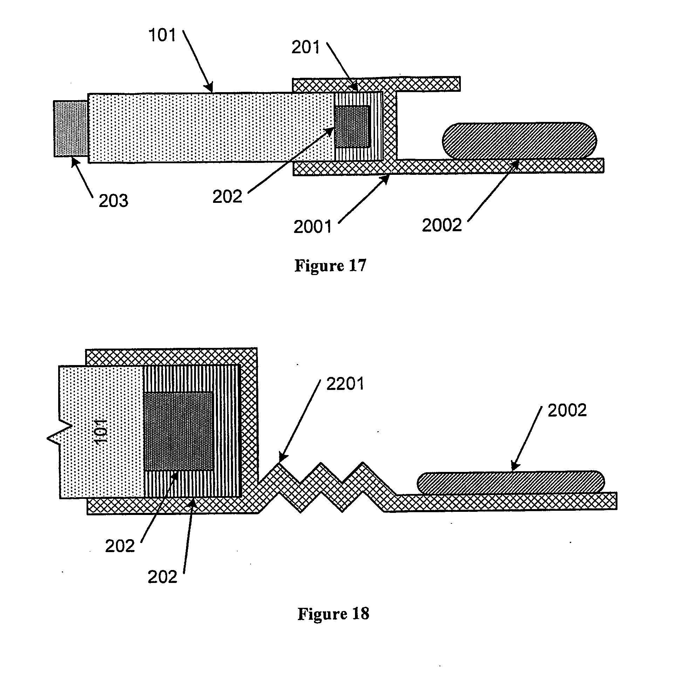

Figure 17 is a schematic cross-sectional view of a sheet-to-bus bar electrical interconnection clip. The top surface and the bottom surface of the clip extend over and under the electrode and a small part of the surface of the elongate solar cell or elongate substrate electrode at the end of the sheet in the string being electrically joined together to the bus-bar. The tabs at the top and bottom surfaces serve to locate and retain the adjoining sheet surface, and the section of fingers extending along the direction of the electrode, parallel to and in line with the central vertical section of the clip serve to draw solder by capillary action to the ends of the fingers, providing a secure joint to the electrode at the remote end of the elongate solar cell sheet or elongate substrate sheet. The solder is shown filling the cavity between the electrode and the inner surface of the clip, while the foot shows a pre-tinned solder pad prepared to accept the bus-bar soldered connection;
Figure 18 is a cross-section detail of a sheet Sub-module assembly to bus-bar connector clip incorporating a stress relief corrugated section between the electrode guide contact surfaces of the clip and the extended foot for the bus bar interconnects. The top surface and the bottom surface of the clip extend over and under the electrode and a small part of the surface of the elongate solar cell or elongate substrate electrode at the end of the sheet in the string being electrically joined together to the bus-bar;

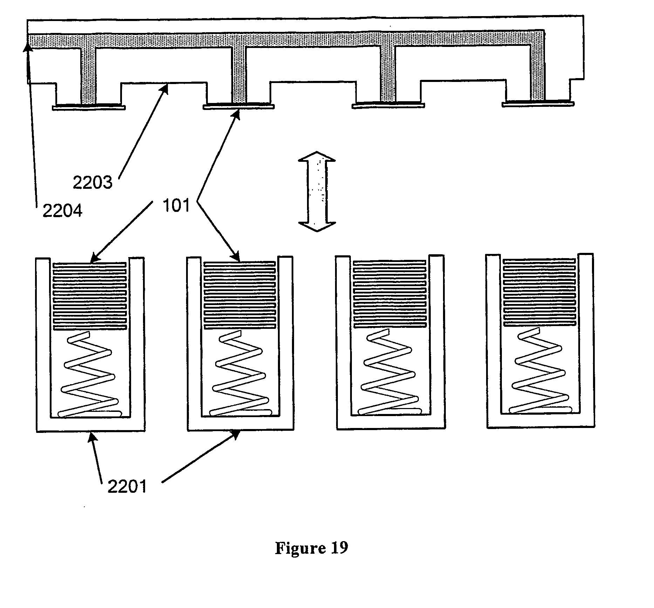

Figure 19 is an array of single-stack cassettes from which a planar array of elongate solar cells or elongate substrates are extracted by a vacuum extraction and transfer head for assembly into sheet sub-modules or sheet pre-modules respectively;

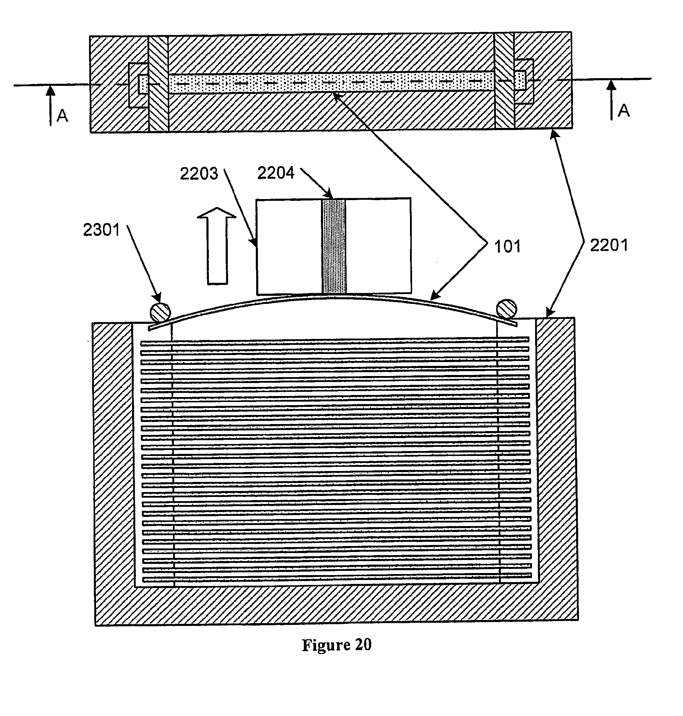

Figure 20 is a schematic plan and cross section of a single stack cassette or a single stack from a multi-stack cassette showing the storage, singulation, and release mechanism as a single elongate device is extracted from the stored stack;

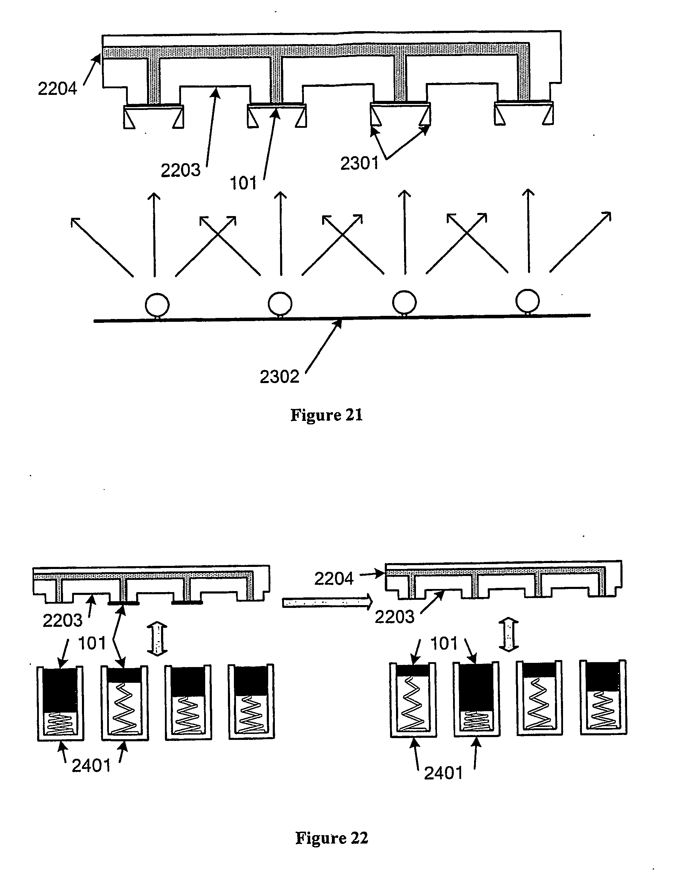

Figure 21 is a schematic of showing a vacuum transfer head presenting a planar array of elongate solar cells to an array of electrical contacts. The array of cells is exposed to standard illuminations so that the individual cells in the array can be characterised by performance and classified for transfer and storage into a sorted bin array;
Figure 22 is a schematic diagram showing the transfer and storage mechanism for sorting and storing characterised cells into performance categories. In a unique, innovative solution to the sorting and binning problem of a large number of cells into a large number of categories for high performance modules, the linear process described herein can accommodate any number of categories of performance without slowing the process, or adding significantly to complexity;

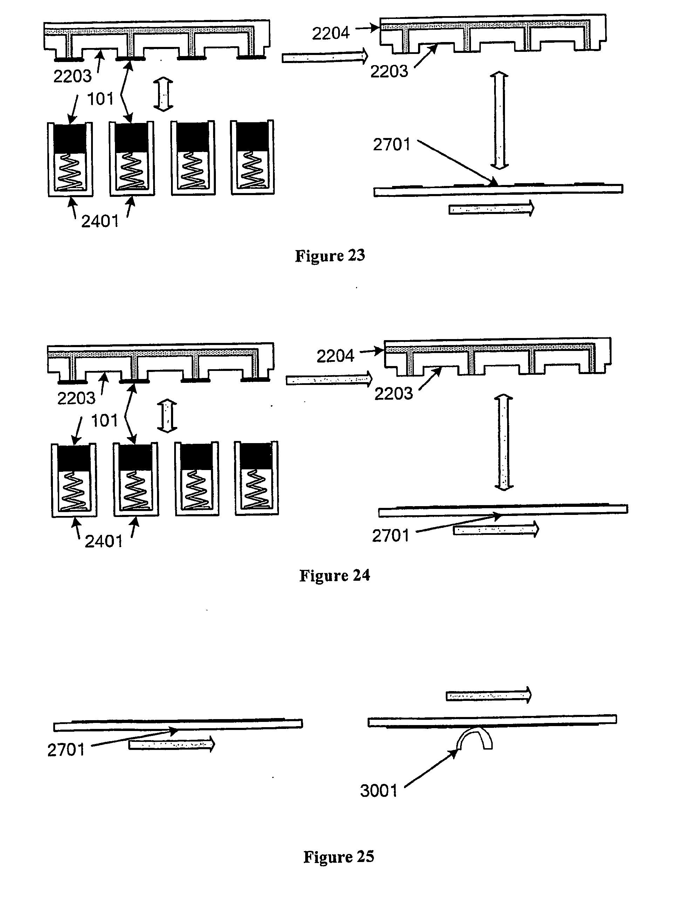

Figure 23 is a schematic diagram showing a vacuum extraction and transfer head extracting a planar array of elongate solar cells or elongate substrates from an array of storage stacks and transferring the parallel mutually spaced planar array to an assembly jig;
Figure 24 is a schematic diagram showing the second part of a two-step assembly process for forming a full-cover elongate solar cell or elongate substrate sheet sub module or pre-module respectively from a double-spaced stack array by filling in every second space with the second assembly cycle;
Figure 25 is an assembled sheet sub-module device held on the assembly jig by swing-arm clamps (not shown) on a conveyor belt. The belt twists through a 180 degree rotation to invert the sub-modules and passes them through the selective wave solder;

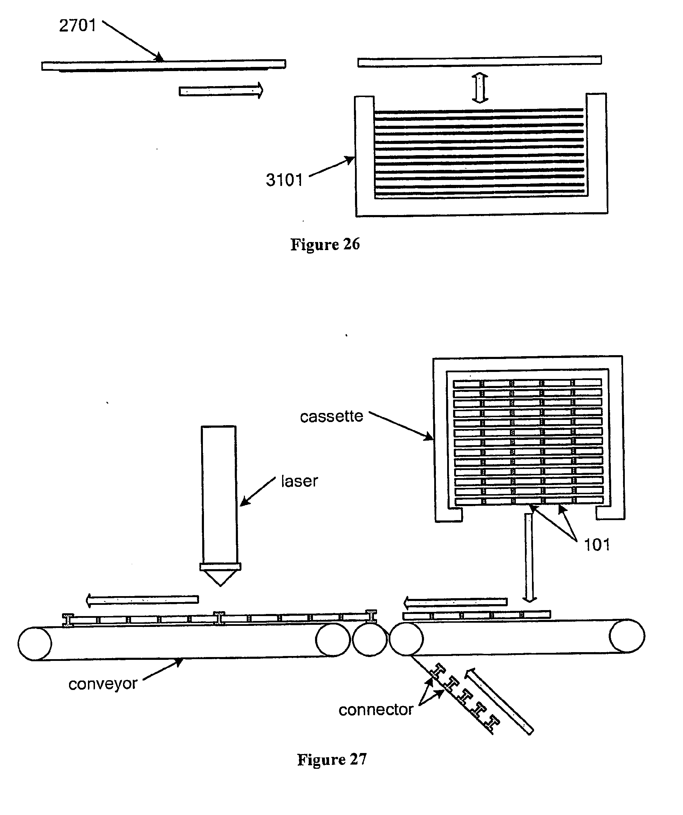

Figure 26 shows the completed sub-module sheet arrays being binned for subsequent processing or assembly stages. In the case of elongate solar cell sub-module arrays, the next stage of processing for the sheets is stringing and assembly for encapsulating in solar power modules, mini- or micro-modules, bifacial flexible sheets or other specific uses. In the case of elongate substrate sheet pre-modules, the next stage of processing will be to convert the pre-modules into solar cell sub-modules via low temperature cell processing;
Figure 27 shows the binned sheet sub-modules being extracted from a cassette and assembled into strings in preparation for encapsulation using the interconnection clips described earlier. The interconnection clips are soldered in-line, preferably using a no-contact laser soldering system; and

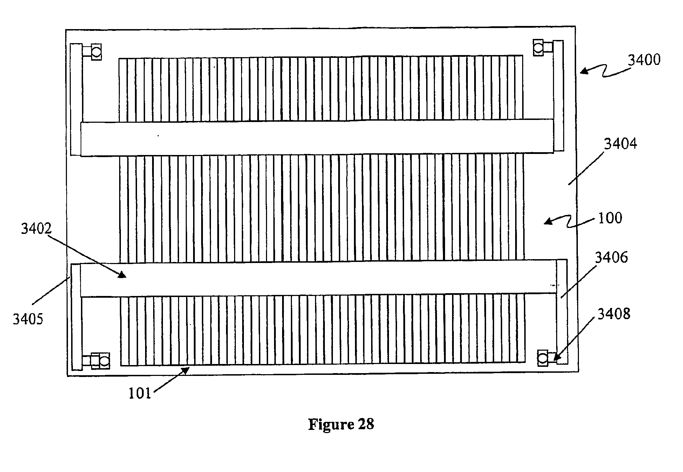

Figure 28 is a schematic plan view of an elongate substrate or solar cell clamp for securing elongate substrates during the application of an electrically conductive material between opposing longitudinal edges of the elongate substrates.

### DETAILED DESCRIPTION OF THE PREFERRED EMBODIMENTS

### Sheet Sub-Module Formation

Referring to Figure 1, an array of 36 elongate bifacial solar cells 101, or elongate semiconductor substrates 101, is assembled to form an assembly referred to herein as a "sheet" sub-module or pre-module 100, or more conveniently as a 'sheet assembly' or 'sheet' 100. The elongate substrates (which preferably, but not necessarily, incorporate functioning solar cells therein) can be in the form of slivers (as described above) or planks and the sheet may therefore also be referred to as a 'sliver sheet' or 'plank sheet', as appropriate. The electrical interconnections are provided by an electrically conductive material disposed between the opposing longitudinal edges of the elongate substrates 101, maintaining them in substantial mutual abutment. That is, the electrically conductive material not only electrically interconnects all of the elongate substrates 101 in a sheet, but also is the means by which the elongate substrates 101 are held together to form the self-supporting sheet 100. Because it is only the electrically conductive material that maintains the elongate substrates in the longitudinally parallel arrangement by engaging only the opposite edges of each elongate substrate, the opposite faces of each substrate remain entirely exposed and hence available for power generation (once functioning solar cells have been formed in the substrates).

The sheets can be formed in sizes similar to conventional solar cells, typically 10 cm x 10 cm, or 12 cm x 12 cm, or even 15 cm x 15 cm or more. This allows each sub-module assembly to be incorporated as an (aggregate) "cell" in a photovoltaic device, allowing the use of similar techniques and apparatus for testing, binning, handling, assembly, stringing, encapsulation and electrical connection to those currently used for conventional solar cells. However, a significant difference is that each sheet will have a much higher voltage and a correspondingly proportional lower current than a typical conventional solar cell. If the elongate cells in the sheets are connected in series, as is typically the case, the sheet voltage is the product of the individual elongate solar cell voltage and the number of cells in the sheet. Similarly, sheet current, when compared with a conventional single-junction solar cell of similar area and performance, is reduced by a factor corresponding to the number of elongate solar cells in the sheet sub-module assembly. This has significant advantages for module design, performance, sub-module layout, reverse bias protection, system voltage, and the size, weight, and specification of electrical current-carrying components within the solar power module.

Arrays of any size can be formed, with any number of elongate solar cells or substrates 101 electrically interconnected in series up to the number that provides a desired system voltage. For example, a sheet sub-module formed from an array of 100 Sliver® solar cells typically measures 100 mm X 102 mm and would generate about 40 mA of electrical current at around 60 V. The sheet sub-module 100 shown in Figure 1 has four separate series interconnections 102 between adjacent cells. The actual number, size, and spacing of interconnections between adjacent cells can be selected advantageously to provide redundancy between connections, reduce the thickness of electrode material between the parallel interconnections, provide physical stability to the sheet structure, and accommodate flexibility requirements. The spacing 104 between adjacent elongate solar cells 101 or elongate substrates 101 is shown in Figure 1 as being wider than necessary in practice, simply for the sake of clarity. In the general case, the width 106 of the elongate solar cells or substrates cells 101 can range from around 0.7 mm up to about 2 mm or even 3 mm. The thickness of the electrode metallisation (corresponding to the thickness of material deposited and the spacing 104 between adjacent elongate cells 101) is typically of the order of 2 µm to 3 µm. In the general case, the spacing 104 between cells 101 can range from effectively zero (whereby adjacent cells 101 abut one another and are sweated together by a solder reflow operation without the addition of solder paste using preformed, previously deposited, or existing solder material on the electrodes to form electrical interconnection and provide physical support for the sheet structure) up to a spacing of several tens of microns. Typically, the spacing 104 between cells 101 is of the order of 5 µm to 20 µm, and is preferably close to 5 µm. Thus the spacing 106 between adjacent elongate substrates or solar cells 101 is typically around three orders of magnitude smaller than the width 106 of the substrates or solar cells 106 themselves, so that the latter are substantially in mutual abutment.

The electrical interconnections 102 between adjacent elongate substrates or solar cells 101 are preferably formed by a selective wave solder process, as described in the solder process patent application. The precise separation between adjacent electrodes depends on the type of solder and flux used, the temperature and temperature profile of the solder process, and the time spent above liquidus in the solder joint material during the solder process. These factors control the viscosity of the solder, the surface tension of the solder bead, and hence to some extent the quantity of solder material retained in the solder joint, and also the solder wettability of the surface of the elongate electrode metallisation material, which assists in controlling the extent of the joint beyond the region of the selective wave solder fountain. By controlling the extent and quantity of flux, and the solder process parameters, the extent of the joint beyond the region of the selective wave solder fountain can be controlled by managing the capillary action of the solder in the joint while the solder material is above liquidus. Further details of the process can be found in the solder process patent application.

The cells 101 are mechanically attached to one another at mutually spaced locations along the length of the electrodes or contacts formed on the longitudinal edges of each elongate substrate 101, preferably using metal solder, although conductive epoxy or a similar material can also perform the electrical and structural functions of the solder. In Figure 1 there are four sections or stripes of serial interconnections 102, each section occupying approximately 5% of the length of the electrode on each sliver®. In practice, the extent and frequency of these serial interconnections 102 can be selected to accommodate interconnection redundancy requirements, electrode metallisation thickness, and warp control requirements. The number of stripes 102 is insignificant from a process perspective since the entire stripe array can be established in a single pass by including an extra fountain in the wave solder machine. This can be achieved by using a single multi-fountain head array. The quantity and placement of the solder, particularly the placement and distribution relative to the plane of the sheet, are important parameters to control in order to ensure that a warp-free sheet is produced, as described further below.

Figure 2 shows an enlarged view of a portion of the sheet sub-module assembly 100 of Figure 1. Serial electrical interconnections 102 between the solar cells 101, connecting the n-contact 202 of each cell 101 to the p-contact 203 of the adjacent cell are formed by depositing a conductive material at mutually spaced locations along the electrodes at the edges of the elongate cells or substrates 101. In Figure 2, only one section of electrical interconnection around 3 mm long is shown on a portion of the elongate solar cell or substrate sheet 100 around 10 mm long. The width of the conductive material and electrodes is greatly expanded in scale in this diagram for clarity. The conductive material is preferably solder, and more preferably lead-free solder, and is preferably and advantageously deposited using a selective wave solder process as described in the solder process patent application. However, the conductive material alternatively can be an evaporated metal film, bonded metal foil, B-stage conductive adhesive film, or conductive epoxy. Electronic devices such as bypass diodes or logic devices can be included in the circuit where appropriate.

In one preferred embodiment, the selective wave solder process parameters are selected so that a minimal quantity of solder 301 is retained in the electrical connections 102 within the sheet 100. Figure 3 is a detailed cross-sectional view through several elongate solar cells 101 or elongate substrates 101 in a sheet 100, illustrating a typical cross-section profile of the electrical interconnection 102 which electrically interconnects the p-type electrode 202 of each cell in series with the n-type electrode 203 of the adjacent cell. A suitable set of basic wave solder machine parameters for this process includes a transport speed of 320 mm.s⁻¹, sheet sub-assembly infra-red preheat for 20 s, and solder temperature of 285 °C with a wave immersion of 2 mm depth. The properties of this elongate solar cell sheet 100 make it particularly suitable for flexible module applications, light-weight and high efficiency applications, and small, thin, mini- or micro-module applications.

In particular, modules of the form illustrated in Figure 3 are suitable for light-weight, robust, bifacial applications such as powering portable consumer electronics, portable small battery chargers, portable power devices for communications such as satellite phone or GPS devices, integrity and security sensors such as power for glass breakage sense-and-report monitors, remote sensors and sense-and-report applications for agricultural, mining, weather, research, or security and for direct powering or indirect powering through battery-charging operations for these devices and applications.

Furthermore, simple modifications of the devices listed above produce new devices that are particularly suitable for security or military applications. For example, elongate solar cell sheets 100 such as those described above and shown in Figures 1 to 3 are fully bifacial and have high areal efficiency, which assists in minimising the module footprint, and can be constructed from very high efficiency elongate solar cells, which further minimises the area required for a given power output. In addition, since the modules are fully bifacial, the orientation of the device or module is not critical for maximising power output. This feature alone can make mini- or micro-solar power modules and devices constructed from elongate solar cell sheets suitable for providing electrical power in applications or situations where it may not be convenient or possible to correctly orient the device for maximum power output. Security device location, battlefield applications, or remote covert monitoring or data gathering applications may restrict the module orientation, which would make the application unsuitable for conventional mono-facial solar cells, but bifacial modules can accommodate these restrictions without the major reductions in daily power output suffered by conventional mono-facial modules. Furthermore, anti-reflection coatings can be applied to the bifacial sheet sub-modules to improve performance as well as reducing the possibility of detection, or compromising device security, by reducing reflection. Also, because the bifacial elongate sheet sub-modules are flexible, the mini- or micro-power module can be flexible and lightweight, or the sheet sub-modules can be encapsulated between thin sheets of acrylic or polycarbonate, which are partially flexible, to produce an impact or shock-resistant, bifacial, high efficiency mini-module. In order to improve the flexibility and shock-resistant nature of these micro- and mini-modules, an encapsulant such as Wacker Silicone RT-67S or similar material is preferably used. This material is optically clear, and much more flexible than cured EVA.

In another preferred embodiment, the solder process parameters are selected so that a maximal quantity of solder 401 is retained in the electrical connections 102 within the sheet 100, as shown in Figure 4. A suitable set of basic machine parameters for this process includes a transport speed of 260 mm.s⁻¹, sheet sub-assembly infra-red preheat for 10 s, and solder temperature of 265 °C with a wave immersion of 0.5 to 1.0 mm depth.

In practice, the electrodes 202, 203 are not rectangular blocks on the edges of the bifacial elongate cell 101 as shown in the Figures, but typically cover the entire edge and may also wrap around to cover a small portion of one or both faces, or may be in the general form of a bead running along the edge. The location of the electrodes 202, 203 with respect to the faces of the elongate cells 101, the width of the electrodes 202, 203, and whether their position is symmetrical with respect to the edge of the cell 101 are all factors that are taken into account when designing the intra-sheet electrical interconnections 102. The above factors are preferably taken into account in the electrical interconnection design in order to reduce or eliminate warping problems in the elongate solar cell or elongate substrate sheet sub-assemblies 100.

Referring again to Figure 3 and Figure 4, standalone sheet sub-modules 100 of elongate solar cells or elongate substrates 101 can be assembled on a continuous or semicontinuous jig or sheet retainer that clamps the array of elongate substrate or cells 101 for inversion and transport through the selective wave solder station. Advantageously, the jig or retainer is to some extent thermally isolated from the sheet array by virtue of being made of a material with low thermal mass and/or poor thermal conductivity and/or by contacting the sheet array in as few locations as practically possible. In any case, the retainer should not contact the sheet assembly directly above the path of the selective wave solder fountain. This reduces heat transfer through the sheet to the carrier, and eliminates solder migration by capillary action to a location between the top surface of the sheet and the transport retainer or jig. As described in the solder process patent application, the transport speed through the selective wave process is several times greater than the 60 mm.s⁻¹ recommended for conventional applications. The reasons for this are twofold: the thermal mass of the sheet is very small, and the silicon in the elongate devices is an excellent thermal conductor. The advantages flowing from this are rapid process speed, short pre-heat times, low flux usage, reduced cleaning requirements, and high and reliable yields and throughput.

A plurality of elongate solar cells formed by processes such as those described in Scheibenstock or the Sliver® patent application can be assembled to form photovoltaic sheets or concentrator sheets that have a similar size to, and can directly substitute for, conventional solar cells - albeit with substantially different current and voltage characteristics. Furthermore, elongate solar cells made from semiconductors other than silicon, such as GaAs, can also be used to form sheets. The solar cells can be electrically interconnected in series, in parallel, or a mixture of series and parallel, to deliver a desired sheet or concentrator sheet sub-module output voltage and corresponding current. If the sheet sub-module output voltage is sufficiently large to allow sheets within a module to be connected in parallel, or even a small number of these sub-module assemblies to be connected in series to form groups that are connected in parallel, then the effect on module output of a section of a sheet, or a sheet, or a group of sheets that has a low current (for example, caused by shading) is significantly less than in a conventional photovoltaic module where a portion of a single large cell, or a group of large cells is of comparable size to the shaded or partially shaded section of the sub-module assembly of a plurality of elongate solar cells.

Referring to Figure 5, wrap-around electrodes 502, 503 can be formed on adjacent surfaces of each solar cell 101 by the angled evaporation of metal 501. Selection of the angle of evaporation 505, and the spacing 504 between the adjacent faces of the elongate solar cells 101 during evaporation allows control of the degree or extent of metallisation intruding across the face 506 of the elongate solar cell 101 adjacent to the exposed edge. This arrangement can be used in conjunction with shadow-masking along the direction of the length of the elongate solar cell 101, with the direction of the shadows running transverse to this direction in order to cause the partial metallisation of the face to be intermittent so that shading of the solar cell caused by the metal during normal operation of the cells 101 in the finished module is proportionally reduced. The solar cells can be held in a jig for the purpose of establishing the partial metallisation described above. Some methods of manufacturing elongate solar cells, such as the Sliver® process described in the Sliver patent application, naturally produce an array of cells as shown in Figure 5, prior to their separation from the wafer frame.

The angled evaporation can be used in conjunction with the minimum solder process shown in Figure 3 to produce a sheet assembly of the form shown in Figure 6. Figure 6 is a cross-sectional end view through several elongate solar cells 101 or elongate substrates 101 of the sheet assembly with electrodes 502, 503 formed by angled evaporation. A typical cross-section profile of the electrical interconnection material 601 is shown, which electrically interconnects the p-electrode 502 in series with the n-electrode 503 of the adjacent cell. In this embodiment, solder is deposited using a selective wave solder process with solder process parameters set so that a minimal quantity of solder 601 is retained in the electrical connections 601 within the sheet 100. Because of the non-symmetric nature of the angle-evaporated electrodes, the face of the sheet from which the selective wave solder operation is performed is important, and will produce markedly differing results. In the case of the sheet in Figure 6, the wave solder is deposited from the side that has no electrode intrusion over the face of the elongate solar cell or elongate substrate. A suitable set of basic machine parameters for this process includes a transport speed of 320 mm.s⁻¹, sheet sub-assembly infra-red preheat for 20 s, and solder temperature of 285 °C with a wave immersion of 2 mm depth. The properties of this elongate solar cell sheet make it particularly suitable for flexible module applications, light-weight and high efficiency applications and small, thin, mini- or micro-module applications. In particular, sheet assemblies of the form illustrated in Figure 6 are suitable for all the applications described above for the sheets of the form shown in Figure 3.

Similarly, the maximal soldering process described above and shown in Figure 4 can be combined with angled evaporation to form a sheet assembly of the general form shown in Figure 7. Figure 7 is a cross-sectional end view through several elongate solar cells 101 or elongate substrates 101 with angled evaporation electrodes 502 and 503 in a sheet 100, and showing a typical cross-section profile of the electrical interconnection material 701. In this case, in contrast to the sheet device shown in Figure 6, solder is deposited by a selective wave process from the side over which the angle evaporated electrode partially protrudes across the face of the elongate solar cell or elongate substrate. The quantity of solder retained in the electrical interconnection 701 is determined by using a selective wave solder process with solder process parameters set so that a maximal quantity of solder is retained in the electrical connections 701 within the sheet. A suitable set of basic machine parameters for this process includes a transport speed of 240 mm.s⁻¹, sheet sub-assembly infra-red preheat for 10 s, and solder temperature of 285 °C with a wave immersion of 0.5 to 1.0 mm depth.

In practice, the electrodes on the edges and parts of one face of the bifacial elongate cells may not be of uniform thickness and/or rectangular cross-section, but rather the thickness may change in the areas where the electrode wraps around the face, and the thickness may also taper or feather on the extreme edge on the face. In such cases, the extent or limit of the solder across the face may be difficult to control since the electrode material, being extremely thin at the edge of the electrode on the face of the device may dissolve non-uniformly in the solder, producing an irregular edge. Apart from the poor visual aesthetics, which are of no performance issue, this can introduce warping of the sheet. The easiest way to overcome warping due to this problem is to ensure that the maximum quantity of solder is retained, thus proportionally reducing the impact of small variations on one side of the sheet.

The assembly and mounting processes, and the electrical and physical connectivity structures described herein prevent damage to the elongate solar cells or electrical connections or physical connections resulting from thermal cycling during manufacture and/or use. In particular, the differential rates of thermal expansion between the electrical and physical connectivity material, the elongate solar cell electrode and metallisation material, and the crystalline silicon solar cells need to be carefully managed to prevent destructive stresses from developing in the elongate solar cells and the connective material. For example, this stress limitation can be achieved by curving the elongate solar cell sub-module assembly prior to forming the connections in such a way that on cooling, or curing, depending on the particular connective material used, the internal stress is minimised at a temperature around the normal device operating temperature, or approximately midway between stress extremes at the extreme test temperature excursions for the device. In the case of a device designed to meet IEC 1646, IEC 1215, or IEC 62108 standards the extreme temperature excursions of interest are -40 °C and +90 °C.

Alternatively, the optimal stress limitation point may be modified, or shifted in the operating temperature range to provide a sub-module that is substantially flat at the selected subsequent assembly stage of forming an electrically connected sequence of sub-modules into rows/strings or arrays in preparation for encapsulation. This can also be achieved by curving the elongate solar cell sub-module assembly prior to forming the connections in such a way that on cooling, or curing, from the electrical connection formation stage temperature or the solder solidus/liquidus transition, depending on the particular connective material used, the internal device stresses induced from the temperature change between the process temperature and ambient temperature for the next assembly stage are balanced in such a manner that the device is sufficiently planar for the next process step. Alternatively, and by applying the same methods outlined above, the two competing requirements can be adequately satisfied by optimising for the two competing requirements and choosing a stress point somewhere between the two individually optimised points. Either of the two methods described above can be used to limit induced stress below the destructive thresh-hold, and provide a stable, robust, and durable device of suitable planarity for subsequent assembly operations.

With reference to the plan view of Figure 8, in some cases it is useful to be able to apply conductive tracks 804 across the surface of a face of an elongate solar cell 101 or elongate substrate 101 without establishing electrical connection to regions doped by diffusions, such as the p-diffusion 802 or the n-diffusion 803 or the semi-conductor material of the cell or substrate 101 under the protective oxide, nitride, or AR coat. For example, a useful additional feature enabling the parallel interconnection of adjoining elongate solar cells or elongate substrates or groups of cell or substrates is the ability to establish electrically insulated (from the cell or substrate) conductive tracks 804 on the cell or substrate face to electrically connect an electrode 805 on one longitudinal edge of a elongate solar cell or elongate substrate to an electrode 805 on the opposite edge of the same elongate cell. For example, the n-contacts 805 (or the negative electrode 805) on one edge of an elongate cell can be connected to n-contacts 805 on the other edge of the same cell. The p-contacts 806 (or the positive electrode 806) on one longitudinal edge of the elongate cell can be connected to p-contacts on the opposite edge of the same elongate solar cell. The n and p contacts on the particular elongate solar cell remain electrically isolated from each other to avoid short-circuiting the cell. To enable ease of contact of the two physically (but not electrically) opposite electrodes, the parallel interconnections 804 are screen-printed onto the surface of the individual elongate solar cell 101 or elongate substrate 101 at an appropriate location on the elongate cell or substrate sheet assembly to interconnect the corresponding electrodes on the same cell or substrate sheet in a disjoint array of short lines. In general, the screen-printing is performed prior to the selective wave solder process. This allows the solder process to bridge any small gaps between the parallel-interconnection screen-printed lines and the electrodes.

In the case of sheets 100 formed from elongate solar cells 101 or elongate substrates 101 having wrap around electrodes, the parallel interconnections 804 are formed on the face of the cell 101 or substrate 101 over which the angled evaporation 501 extends partially to provide electrode metallisation 502, 503. Advantageously, in the case of sheets used in concentrator applications, the parallel interconnection 804 can serve the dual purpose of providing electrical interconnection as well as a location and method for attaching the concentrator sheet to a receiver of the concentrator to provide physical bonding as well as a thermal connection for heat-sinking the solar cells. Additionally, for mono-facial solar power modules and concentrator receiver modules based on sheet assemblies, partial coverage or shading of the rear surface of the sheet sub-assembly is not a problem. In the case of bifacial solar power modules, the width of the lines can be reduced so that shading does not significantly compromise performance of one side of the sheet or module with respect to the other side.

One reason to connect the electrical contacts or electrodes on the two opposite longitudinal edges of the same elongate solar cell or elongate substrate together electrically is to reduce electrical resistance losses arising from electrical current having to cross *through* the width of the elongate solar cell 101. This is particularly important for elongate solar cells as the width of the cell increases, or where elongate solar cells are used under concentrated sunlight where the current flow is high because the illumination intensity is high. In general, all other parameters being constant, the short-circuit current a cell produces is linearly proportional to illumination intensity, and the open-circuit voltage a cell rises to is proportional to the logarithm of the intensity.

For an elongate solar cell operating at any given current, the resistance loss within the cell between the two electrodes is proportional to the square of the width of the elongate solar cell. However, if n-contacts are present on both long edges and p-contacts on one edge alone, or if p-contacts are present on both edges and n-contacts on one edge alone, then the effective "electrical" width of the cell (for electrical resistance purposes) is halved, and the resistance loss within the elongate solar cell is therefore quartered. An elongate solar cell with this configuration of contacts can be twice as wide, and yet have the same resistance loss as, an elongate solar cell having only n-contacts on one edge and p-contacts on the other edge.

A very important cost factor for the commercial production of Sliver® cells is the thickness of the original wafer from which the slivers® are formed. As micro-machining techniques improve, it is possible to decrease the pitch of the elongate slots or openings formed through in the wafer, making both the openings and the elongate substrates so produced, thinner, and improving the active surface multiplying factor of the process. Similarly, increasing the thickness of the wafer, and therefore the width of the elongate substrates produced, reduces the number of elements required to be handled and tested and placed and electrically interconnected. Defect-free micro-machining, substrate pitch, and wafer thickness are key cost drivers in the Sliver@ technology development process. Substrate pitch is limited by, among other factors, anisotropic etch ratios, which, for any given pitch, determines the limiting wafer thickness. Cost models are strong drivers for wider substrates, which are produced from thicker wafers, but performance modelling shows that the optimum substrate width is 0.75 to 1.25 mm. However, this relates only to elongate substrates or elongate cells with opposite polarity electrodes only on opposite longitudinal edges of the device. By incorporating the parallel interconnection as described above in relation to Figure 8, the width of the substrate can be doubled to 1.5 to 2.5 mm with no performance loss, thereby effectively halving the number of devices requiring separation, handling, storage, assembly, and electrical interconnection. For any given one-sided micro-machining technique, the effective thickness of wafer that can be processed can be doubled by a two-sided alignment and etch process. The key to being able to practically implement double-width elongate Sliver® cell and substrates is the simple, yet very valuable and effective, parallel interconnection process of individual cells as described above.

Figure 8 shows one method of using a stencilled or screen-printed or evaporated metal or printed organo-metallic ink track 804 on an elongate substrate or elongate solar cell 101 to electrically interconnect two edge contacts of the same polarity 805. A similar function could be achieved using a combination of screen-printing and solder rather than stencilling, where the same electrical interconnections are performed across regions of the surface of the solar cell or substrate. There are many other methods for establishing lines of electrical interconnection, such as those described in the solder process patent application that are applicable here.

More particularly, it may be that only the n-contacts 805 of the n-diffusion 803 on each edge of the elongate cell 101 are electrically interconnected using the tracks 804 on the face of the device 101. This arrangement is suitable for an elongate solar cell in which electrical resistance in the n-type diffused emitter (which in some elongate bifacial solar cells covers the active faces of each cell) dominates. If it is the case that electrical resistance in the substrate, that is, the bulk p-type semi-conductor forming the centre of the device, is also an important consideration, then both n and p contacts can be present on each edge and can be electrically connected in order to reduce or minimise the electrical resistance, as described above.

Series connections between adjacent cells 101 in the elongate solar cell sheet or elongate substrate sheet sub-module assembly are established from the p-contact 806 on the p-diffusion 802 of one cell, to the n-contact 805 on the adjacent cell, via the selective wave solder-formed metallisation 102 on the adjacent electrode material. Some types of elongate solar cells and elongate substrates have metallisation deposited for electrodes and electrical contacts only on the edges of the solar cell or substrate. During the assembly of some forms of sheet and concentrator sheet sub-module assemblies, it is sometimes convenient that the electrode metallisation of the elongate solar cells or substrates wraps around onto one face of the solar cell immediately adjacent to the edge, but preferably not onto the other, or opposite, face which is also immediately adjacent to the edge but which will be directed towards the top or sunward side of the sub-module assembly during operation when incorporated in the solar power module.

Referring to Figure 7, elongate solar cells 101 that have partial metallisation on the cell face 506 are suitable for applications where the elongate solar cell is to be soldered or otherwise directly electrically connected to a substrate or superstrate, or where a protruding solder joint 701 on the angle-evaporated electrode 502 and 503 is to be used to physically mount the sheet device in an electrically isolating manner, or is to be used to thermally connect the sheet to a heat sink. The electrical interconnections can be established using conventional lead-tin solder, or lead-free solder, or conductive polymers, or conductive epoxies, or conductive elastomers applied directly to the electrode surfaces 502, 503. The conductive tracks 804 can be applied to, or formed on, the face of the elongate cells or the elongate substrates beforehand by screen printing, masked metal evaporation, direct writing or printing of conductive inks or pastes or organometallic materials by inkjet printing, pad printing, B-stage transfer processes, or other suitable material transfer techniques. Alternatively, the conductive tracks 804 can be applied to, or formed on, the faces of the cells or substrates after the cells or substrates have been formed into loose sheet arrays, by screen printing, masked metal evaporation, direct writing or printing of conductive inks or pastes or organometallic materials by inkjet printing, pad printing, B-stage transfer processes, or other suitable material transfer techniques. Similar processes can be applied after the substrates or cells have been formed into physically and electrically interconnect sheets. Preferably, the physical connections and the serial electrical interconnections, as well as the parallel electrical interconnections are all performed simultaneously using the selective wave solder process described in the solder process patent application.

The connection 804 between the same-polarity electrodes of individual elongate solar cells or elongate substrates can be a multi-purpose connection that provides the means for electrical connection, thermal connection, and the structure for mechanical adhesion of adjacent devices ensuring the physical integrity of the structure. For example, adjacent elongate solar cells, or adjacent elongate substrates, can be secured together to form elongate sheets solely by solder, which provides all the appropriate electrical, thermal, and mechanical properties required by the elongate sub-assembly or pre-assembly sub-modules. Furthermore, this avoids the need for any other form of adhesive. Moreover, the solder operation, as described in the solder process patent application, is performed without requiring any form of stencilling, printing, or dispensing. This is a very important and extremely advantageous feature, since dispensing or stencilling of solder paste on the scale necessary for the large-scale production of sub-module assemblies is an expensive process with respect to infrastructure tools, consumables, process materials, time, cleaning, and waste disposal.

Eliminating the solder paste application step simplifies the assembly process by removing a series of slow process steps such as printing, reflow, and cleaning, tool cleaning, consumables, and waste handling, along with associated yield and reliability issues. The entire solder process used to form standard solar cell assemblies is thus replaced by a single, clean, very fast, reliable, high yield, and simple process step that forms solder interconnections without the requirement for adhesives, without the requirement for expensive tools, without the requirement for additional expensive materials, without the requirement for additional complicated handling steps, and without the requirement for additional waste handling and disposal. A particularly advantageous solder process is described in the solder process patent application, the entire contents of which are incorporated herein by reference.

Although it can be advantageous to space the solar cells apart from one another, such as in the process described in the rafts patent application, if the elongate cells can be produced cheaply enough, this changes the balance of cost drivers towards maximising module efficiency to reduce related costs such as packaging and materials, rather than primarily to reduce incorporated silicon cost, which is the case if silicon is the major cost item. With recent wide-ranging improvements in 2^{nd} Generation Sliver® Technology, such as those described herein, where the cost of the silicon wafer feed-stock has been significantly reduced compared with conventional modules solar power modules, and reduced to a minor proportion of the finished elongate solar cell module cost, the primary cost driver in dollars per watt module power output is now cell efficiency, and more particularly sub-module areal efficiency, and hence module aperture efficiency. Related to these cost drivers are significant enabling technology advances requiring improved sub-module designs, improved sub-module handling and assembly, and improved test and binning and buffer storage - the motivation for the methods and processes described herein.

In one preferred embodiment, referred to in this specification as "concentrator sheets", the elongate solar cells are electrically and physically interconnected in a continuous or semi-continuous manner along the length of the electrode or electrode metallisation on the edge of the elongate solar cell in such a way that the entire surface of one face of the concentrator sheet is free from protrusions of conductive material beyond the exterior plane of the surface; that is, where one of the faces of the sheet formed by the faces of the elongate solar cells is substantially planar and is free from conductive material lying beyond the plane of the surface of the concentrator sheet. Alternatively, the conductive material and obstruction-free area can be confined to tracks or pathways, preferably in a parallel or multiple-parallel fashion extending across the surface in a direction transverse to the longitudinal axes of the elongate substrates. The protrusions, if any, between these planar areas can be accommodated in mating grooves running the length of the receiver. The conductive material-free surface is used for mounting the concentrator sheets on the receiver assembly to provide good mechanical support and good thermal contact for heat-sinking the concentrator sheets. The natural insulation properties of the oxide or oxide/nitride stack on the surface of the elongate solar cell and hence the mounting surface of the planar surface of the concentrator sheet can be augmented by using an insulating mounting medium such as thermally conductive but electrically insulating epoxy or B-stage adhesives with similar properties, or tape mounting options such as Chomerics Tape. This arrangement is particularly applicable to use under concentrated sunlight.

Alternatively, the elongate solar cells can be electrically and physically interconnected in a continuous or semi-continuous manner along the length of the electrode or electrode metallisation on the edge or surface of the elongate solar cell in such a way that there exist pathways across the length of the elongate solar cells and therefore also along the length of the concentrator sheet. These pathways can be from the order of millimetres to centimetres wide. The pathways are regions on one face of the concentrator sheet where the surface of the sheet formed by the elongate solar cells is substantially planar and is free from conductive material lying in that plane. This arrangement is particularly suitable for elongate solar cells where the electrical contacts are on the surface of the cell, and preferably on the rear surface of the cell. The electrical and physical regions of contact are confined to stripes running the length of the concentrator sheet, transverse to the longitudinal axes of the elongate devices. The stripes may be of the order on millimetres to centimetres wide, separated by conductive material pathway-free regions or stripes that may also be of the order of millimetres to centimetres wide.

The conductive material-free pathway regions are used for mounting the concentrator sheets on the receiver assembly to provide good mechanical support and good thermal contact for heat-sinking the concentrator sheets. The natural insulation properties of the oxide or oxide/nitride stack on the surface of the elongate solar cell and hence the pathway region of the planar surface of the concentrator sheet can be augmented by using an insulating mounting medium such as thermally conductive insulating epoxy or B-stage adhesives with similar properties, or tape mounting options such as Chomerics Tape. The surface of the heat sink or receiver mounting surface is recessed with grooves running the length of the receiver assembly to accommodate the protruding electrical interconnections, which also provide physical support for the sub-assembly structure. The concentrator sheets are mounted and heat sunk through the lands between the grooves accommodating the electrical connections. This arrangement is also particularly applicable to use under concentrated sunlight.

Elongate solar cells are particularly suitable for use in concentrated sunlight applications because they have a high-voltage, low-current capability. The maximum power voltage of an elongate silicon solar cell under concentrated sunlight can be as high as 0.75 volts. The typical width of an elongate solar cell is around 0.7 mm to 3 mm. Thus voltage builds at a rate of up to 10 volts per linear centimetre of elongate solar cell assembly array, with the advantage of a correspondingly proportional small current.

Consequently, elongate solar cells, formed from crystalline or multi-crystalline silicon or other solar cell material, mono-facial or bifacial in nature, and whether thin or thick, formed into sub-module assemblies such as concentrator sheets are particularly suitable for use in linear concentrator systems in place of conventional solar cells. Each elongate solar cell can be series-connected to its neighbour along the length (continuously or intermittently) of each edge, or between an edge and a face, or even between faces and edges or faces and faces, depending on the electrode arrangements and whether the elongate cells are bifacial or mono-facial, front surface contact, or rear surface contact, or edge surface contact solar cells.

Electrical current consequently moves substantially only in a direction parallel to the longitudinal axis of the concentrator sheet receiver rather than in a series of alternating transverse and longitudinal (helical) directions as occurs when conventional concentrator solar cells are used. Additionally, the space occupied by the series connections between the elongate cells is comparatively very small for edge-contact elongate solar cells, and effectively non-existent for rear-surface contact elongate solar cells, so that little sunlight is lost by absorption in those electrical connections, which also serve the dual purpose of physical or mechanical support before, during, and after the handling and assembly of concentrator sheet sub-modules. Furthermore, the series resistance loss of the concentrator sheet sub-module assemblies constructed from elongate solar cells, and hence the concentrator receivers constructed from elongate solar cell sub-modules such as concentrator sheets is nearly independent of the width of the illuminated region.

A number of advantages flow from the feature of certain forms of elongate cells that include electrical connections only at the edge of each elongate solar cell. In the sheets and concentrator sheets described herein, electrical connections are not required at two of four the edges of a row of sheets or concentrator sheets, where these "two edges" under consideration are formed by the ends of the constituent elongate solar cells forming the linear array of solar cells within the sub-module assembly, because the connections are provided by way of the one or more conductive pathways on or in the adjacent or abutting elongate solar cell electrode, or electrode metallisation material, or electrically conductive material forming the mechanical support structure between the opposing longitudinal edges of adjacent or abutting elongate solar cell electrodes, and hence the mechanical support and electrical interconnections of the elongate solar cell sheet or concentrator sheet sub-module assembly. This means that several parallel rows of sheets or concentrator sheets can be used on a single concentrator receiver with only a narrow spacing required between each row. In the case of rear-contact elongate sheets, the entire electrical interconnection network can be concealed behind the concentrator sheet and confined to rows or stripes with heat-sinking and mounting planar spaces running alternately parallel between the electrical interconnection.

The width of the spacing between the rows of adjacent concentrator sheets serves solely to meet the needs of electrical insulation and stress introduced by differential thermal expansion between the materials in the concentrator sheet sub-module assembly and the receiver material. Consequently, a receiver constructed from concentrator sheet sub-modules can be relatively wide, up to many tens of centimetres, with virtually no surface area exposed to concentrated illumination wasted on electrical interconnections. For example, a conventional 50 sun concentrator cell presently manufactured measures 42 mm wide by 50 mm long. The minimum receiver real estate area required for this conventional concentrator cell is 65 mm wide, allowing for 2 mm space each side of the electrical connection tabbed bus bars and 51 mm pitch along the length of the receiver. For multiple-row receivers populated with conventional concentrator cells this configuration achieves 63% utilisation of concentrated sunlight. Apart from very poor areal utilisation, this arrangement wastes receiver and encapsulant material, decreases the power to weight ratio of the receiver assembly - which is a very important consideration for tracking receivers - and further compromises system performance by introducing further shading problems from the larger structural members required to support the heavier, less efficient receivers. The wasted active receiver area also means that larger mirrors are required in order to produce the same rated output from the constituent cells.

In contrast, however, for multiple-row receivers populated with concentrator sheet sub-module solar cells, the corresponding configuration can achieve 96% to 98% utilisation of the concentrated sunlight, assuming constituent elongate solar cells of the concentrator sheets are 50 mm long and 100 mm long respectively, with a 2 mm gap between the rows of sheets. Apart from thermally induced stress along the length of the receiver, there is no physical limitation to the effective or practical length of a concentrator sheet assembly up to system-voltage length. Therefore, there is no requirement for frequent gaps between cells as is the case in conventional concentrator receivers. The concentrator sheet provides excellent areal utilisation, eliminates wasted receiver and encapsulant material, and significantly increases the effective power to weight ratio of the receiver assembly - which, as mentioned earlier, is a very important consideration for tracking receivers - and further enhances system performance by reducing shading problems by reducing the size of structural members required to support the lighter, more efficient receivers. The reclaimed active receiver area also means that smaller mirrors are required in order to produce the same rated output from the constituent cells. Alternatively, system performance can be increased by using concentrator sheet receivers on standard mirrors, or costs can be reduced without compromising performance by using lower quality, cheaper mirrors.

The use of concentrator sheet sub-modules has particular advantages in concentrator applications where multiple mirrors or wide mirrors reflect light onto a single fixed receiver. In such an application, each of the rows of concentrator sheets will have a fairly uniform illumination intensity or light flux in the longitudinal direction, that is, along the length of the receiver, although the illumination level may be different for each row, that is, across the width of the receiver.

In applications where wide or multiple mirrors are used, it is difficult to control series resistance, manage the problems associated with uneven illumination across the width of a wide receiver, and minimise wasted space between rows and cells if conventional concentrator solar cells are used. For the reasons described above, this is not the case with the elongate solar cell concentrator sheet sub-modules described herein.

A further advantage of the sheets and concentrator sheets described herein is that because they are formed from elongate solar cells, the receiver voltage can be large so that the voltage up-conversion stage of an inverter (used to convert DC to AC current) associated with the photovoltaic system can be eliminated. A further advantage is that each sheet or concentrator sheet can be operated electrically in parallel to other sheets or concentrator sheets, respectively, or groups of sheets or concentrator sheets. Alternatively, a group of sheets or concentrator sheets can be series connected, and the groups so formed can be run in parallel with other groups. Because voltage can be built so rapidly with elongate solar cell assemblies it is possible and practical to reach system voltage in relatively short strings/rows of sheets or concentrator sheets, or relatively small solar power modules or relatively short lengths of concentrator receivers, and it is certainly practical to reach system voltage several to many times over in a moderate sized solar power module or concentrator receiver. This means that many strings/rows within a solar power module or along the length of a concentrator receiver can be run in parallel, rather than the generally prevailing requirement for running conventional solar power modules in series to build voltage. Running subsections of a solar power module in parallel has significant advantages for reverse bias protection that can dramatically reduce or eliminate the requirement for protective by-pass diodes, as well as greatly reducing system performance losses due to partial shading, when compared with conventional solar power modules operating under similar conditions.

In the case of flat plate solar power modules, the parallel connection ability between sheets, and between strings of sheets can greatly reduce the effect on module output of non-uniformities in illumination, arising for example from partial shading from debris on the module surface, or encroaching building shading.

It will be apparent that the sheets and concentrator sheets described herein provide a significant advance over existing uses of elongate solar cells, particularly with respect to concentrator applications, and some major benefits over the use of conventional solar cells in flat plate collectors. In particular, the placing of elongate cells one by one into a solar power module or a concentrator receiver is avoided by the use of elongate solar cell sheets or concentrator sheets, each typically including some tens to hundreds of individual elongate cells. Furthermore, the precise placement and materials requirements for electrical interconnections between individual adjacent, adjoining, or abutting elongate solar cells on a large scale area are avoided with the high performance, high areal efficiency elongate sheet and elongate concentrator sheet sub-module assemblies described herein. An even greater advantage is the elimination of the requirement for supportive substrates or members, the preparation of those substrates of members, and the alignment of the supportive members or substrates for the formation of electrical interconnections. Yet a further advantage is the capability to assemble high areal efficiency sub-module sheet assemblies, raising the efficiency of solar power modules containing elongate solar cells, and thus reducing the material cost of the module in dollars per watt of module power output.

Because each such sheet or concentrator sheet is small, the elongate solar cells or elongate substrates can be inexpensively assembled in a mechanical jig that allows sufficiently precise placement of the components. Furthermore, the electrical interconnections between the constituent elongate solar cells or elongate substrates within the sheet and concentrator sheet sub-module can be relatively easily implemented without the problems associated with handling, locating, and heat capacity impediments where the elongate solar cells may be previously attached to a supporting glass substrate as is the case with some prior art solar power modules incorporating elongate solar cells. The desired number of sheets or concentrator sheets, with electrical interconnections incorporated into the sub-assembly structure, can then be deployed to form the solar power module or concentrator receiver respectively with any desired shape, area, current and voltage characteristics, and associated output power. A method and a process for establishing electrical inter-module assemblies connections between elongate solar cells forming sheet or concentrator sheet sub-module assemblies is described in the solder process patent application. That Application also describes several other methods and processes which can be used to form high areal efficiency elongate sub-module assemblies using solely conventional materials, and with no additional structural or support members other than the electrically conductive material, preferably solder or lead free solder - although other conductive pastes, epoxies, elastomers, or silicones - used to establish electrical interconnections.

Similar benefits pertain to the formation of solar power mini-modules from elongate solar cell sheets or concentrator sheets. Mini-modules are small photovoltaic modules that use artificial light (and occasionally sunlight) to power consumer electronics or charge small batteries, and which deliver an appropriate voltage that is generally larger than can be provided by a single solar cell.

The sheets described herein can be encapsulated and mounted on a flexible material such as Lexan® polycarbonate film, fluorinated polymer films such as Tefzel®, polyethylene films such as Tedlar®, and polyimide film such as Kapton® all in sheet, film, or tape form as required for the particular application, so as to form flexible photovoltaic modules by taking advantage of the flexibility of the thin elongate solar cells. It will be evident to those skilled in the art that a very large range of suitable materials, and combinations of these materials, both conventional and un-conventional, including solder and lead free solder, and adhesives and conductive adhesives, and flexible conductive adhesives, can be utilised to form the elongate sheet and concentrator sheet sub-module assemblies described herein.

Another method of taking advantage of the flexibility of sheets and concentrator sheets fabricated using thin and flexible elongate solar cells is to mount the sheet or concentrator sheet conformally onto a rigid curved supporting structure. It is practically impossible to achieve such a goal using conventional solar cells, and it would be very difficult, if not impossible, to achieve such a goal using some form of robotic "pick and place machine" for elongate solar cells. Alternatively, the sheet or concentrator sheet can be mounted onto a flat supporting structure that is then curved to the desired shape.

The ability to fabricate a curved receiver has significant performance advantages for linear concentrator receivers. Not only is the cosine loss eliminated - losses which can be substantial for wide mirrors or short focal length systems - the Fresnel reflection from the front of the receiver is also minimised because the concentrated light is hitting the receiver surface everywhere at normal incidence to the curved surface of both the receiver and the internal concentrator sheet sub-modules. While these losses are always proportional to, and simply a function of angle, for high concentrations the absolute quantity of energy lost does become substantial.

An example of a suitable supporting structure for elongate sheet sub-modules is curved glass for architectural applications. Recent improvements in polymer technology have also delivered UV-stable polymers, and materials such as Lexan® polycarbonate, and UV-stabilised acrylics that are suitable for some architectural applications of solar power modules incorporating curved elongate sheet solar cell sub-modules.

Another example of an application that takes advantage of the flexibility of thin elongate solar cell sheet sub-assemblies is to mount the concentrator sheet onto a curved linear concentrator receiver fabricated from extruded aluminium or other suitable material. One advantage of so doing is that the individual elongate solar cells in the concentrator sheet will receive near-normal incident illumination, even from sunlight reflected or refracted from the edge regions of the linear concentrator optical elements. In the case of concentrator sheet sub-modules constructed from thin flexible elongate solar cells the orientation of the cells and concentrator sheet sub-modules, from a flexibility perspective, is unimportant. However, from a system performance perspective, the concentrator sheet sub-modules should be mounted on the receiver with the long axis of the elongate solar cells transverse to the long axis of the linear concentrator receiver, in order to minimise the effect of concentrated light flux variations across the receiver. The special attributes of elongate solar cell sheets and concentrator sheets means that the sub-modules handle illumination flux variations along the length of elongate solar cells electrically connected in series width-wise, much better than across the elongate cells, which corresponds to varying illumination over a row of solar cells connected in series.

The elongate solar cell sheets and concentrator sheets described herein also address difficulties and provide a solution to some of those difficulties that can occur during the fabrication of solar cells, where it may be inconvenient or difficult to carry out certain cell-processing steps on small solar cells. For example, it may be difficult to metallise one of the faces of an elongate solar cell in order to create a reflector on one surface until the elongate cell is removed from the remaining portions of the silicon wafer from which it was formed, as described in the Sliver patent application. Another example is the application of an anti-reflection coating to the elongate solar cell, which in some circumstances may be more conveniently performed after the electrode metallisation has been completed. This however carries a risk that the anti-reflection coating will cover the electrode metallisation, which would make it difficult to establish electrical contact with each cell. Provided the appropriate materials are selected to form the elongate solar cell sheets and concentrator sheets, layers such as anti-reflection coatings and reflective coatings can be deposited by evaporation, chemical vapour deposition, sprayed deposition, or other means during or after the time when the elongate solar cell sheets and concentrator sheets have been assembled and electrically interconnected, or during or after the time when the elongate substrate sheets and concentrator sheets have been assembled and electrically interconnected into pre-modules in preparation for subsequent cell processing steps.

Similarly, elongate solar cell sheets and concentrator sheets sub-modules can provide a more convenient approach for electrical passivation of the surface of the constituent solar cells. Electrical passivation is sometimes carried out using a material such as silicon nitride deposited by a plasma-enhanced chemical vapour deposition (PECVD) process or by depositing amorphous silicon on the surface of the cell. These coatings obviate the need for high-temperature processing in order to achieve good surface passivation. In some cases it is difficult, or impossible, to carry out this step during normal elongate solar cell processing, principally because PECVD nitride is not a conformal process.

As a particular example of the usefulness of post-assembly elongate solar cell sub-module assembly processing, silicon nitride deposition by PECVD is not conformal. Consequently, it is difficult to successfully coat the surfaces of some forms of elongate solar cells while they remain attached to other portions of the silicon wafer. The process can, however, be successfully carried out during or after the assembly of the elongate solar cell sheets and concentrator sheets sub-modules containing this particular type of elongate solar cell.

Elongate solar cells used to form elongate solar cell sheets and concentrator sheets can be fabricated in several types or categories. The categories include: thin elongate solar cells where a "thin" solar cell is less than 150 microns thick - or simply thinner than a conventional wafer; thin elongate bifacial solar cells where the cell electrodes are on the edges of the cell; thin elongate mono-facial solar cells where the electrodes are on the faces or partially on the faces of the solar cell; thin elongate mono-facial solar cells where the electrodes are in some combination of the faces or the edges of the solar cells; thick solar cells where a "thick" solar cell is defined as a solar cell greater than or equal to 150 microns thick - or simply as thick as the conventional wafer from which it is constructed; thick elongate bifacial solar cells where the cell electrodes are on the edges of the cell; thick elongate mono-facial solar cells where the electrodes are on the faces or partially on the faces of the solar cells; and thick elongate mono-facial solar cells where the electrodes are in some combination of faces and edges of the solar cells.

There are several distinctive features of solar cell sub-module assemblies such as elongate solar cell sheets and concentrator sheets comprising elongate solar cells that distinguish these assemblies from conventional cells and sub-assemblies of conventional cells.

For example, the elongate solar cells are in most cases contained in a substantially planar arrangement. The elongate solar cells are organised in a one-dimensional linear array or row of longitudinally parallel cells where the cells are aligned such that the longitudinal axes of the cells are transverse to the direction, usually defined as the voltage-building direction, of the linear array. This places an electrode edge of one cell adjacent to an electrode edge of an adjacent cell. This contrasts with most devices assembled from conventional cells, or devices assembled from small-area diced conventional cells where the purpose of the assembly of conventional cells or diced conventional cells is predominantly to build the device output voltage to a level suitable for powering small or portable low-power electrical devices such as calculators or for low power battery chargers such as mobile phone chargers or portable music player battery chargers. In such devices the cells are frequently square or near-square, and are frequently organised into a two-dimensional planar array.

The elongate solar cells forming high areal efficiency elongate solar cell sheets and concentrator sheets are fixed in positions relative to adjacent cells with a uniform or near-uniform or a repeating pattern of cells forming the linear array of the sub-module assembly in a manner or arrangement that maximises the active surface area of elongate solar cell exposed to illumination relative to the overall area or footprint occupied by the sheet or concentrator sheet sub-module. The purpose of minimising the spacing between adjacent cells and between adjacent sub-modules is to maximise the surface area of elongate solar cells in any given area of solar power module, thus maximising the power output of the module per unit of module area. In the case of a flat plate, conventionally-mounted solar power module constructed using bifacial elongate solar cell sheet sub-modules. This close-packed arrangement sacrifices the advantages of the bifacial elongate solar cells in exchange for maximising the power output. However, in the case of bifacial solar power modules, the bifacial aspect of these cells is fully utilised, and the power output per unit area of the bifacial module is also maximised.

Modules constructed from elongate solar cell sheet sub-modules can produce very high voltages per unit of area compared with conventional solar cells. Since voltage can be built at a rate of up to around one volt per linear millimetre, compared with conventional modules where the rate is typically around one volt per ten to thirty linear centimetres, even a small PV installation based on elongate solar cell sheet sub-modules can be operated at a voltage which is sufficiently high to allow the elimination of the voltage up-conversion inverter stage, as well as significantly reducing current-carrying capacity requirements associated with low voltage, high current conventional cells and bus bars used in conventional solar power modules that is a serious draw-back for conventional PV module arrays.

Further, significant areas of sub-module assembly cell arrays within modules constructed from elongate solar cell sheet sub-modules can be operated in parallel, whilst still retaining a high module output voltage. This offers significant improvements in annual energy output through reductions in partial shading losses, reduced incidence and extent of solar power module reverse bias operation without the requirement for by-pass diode protection, and other benefits such as lower module and cell operating losses due to cell thermal coefficients compared with conventional cells and modules.

The plurality of elongate cells forming the elongate solar cell sheets and concentrator sheets sub-module assembly are preferably electrically interconnected in an integral manner such that the electrical interconnections between the constituent elongate cells in the elongate solar cell sheets and concentrator sheets sub-module assemblies are comprehensive and complete so that no further internal electrical interconnections within the sub-module assemblies are necessary between the constituent cells upon assembly of the sub-modules to form solar power modules other than the electrical connections between the sheet or concentrator sheet sub-module assemblies themselves, sub-modules sheets or concentrator sheets to bus bars, or between sub-module groups or arrays of sub-modules and bus-bars or sub-module groups and other sub-module groups.

The substantially planar array arrangement of the plurality of elongate cells can be assembled into functional sheet or concentrator sheet sub-modules without any external or additional support structures or physical support members other than the electrically conductive material forming the electrical interconnections between adjacent elongate solar cells.

In photovoltaic module applications that require the constituent solar cells to be heat-sunk, such as in concentrator systems, the elongate solar cells can be thermally connected to the heat-sink via the cell surface, or via a metallised part of the cell array such as the contact strip 804. In concentrator sheet sub-module assemblies, such as that shown in Figure 9, this thermal connection between the cells 101 and the heat sink 903 can be accomplished using thermally conductive adhesive, or very thin layers of conventional adhesive such that the thermal resistance is sufficiently small, or by means of the material used to create electrical connections 201 between the elongate solar cells 101 and between the elongate solar cells 101 and the mounting or heat-sink connecting substrate 901 and the heat-sink 903. In particular, the electrical interconnections 201 can be established using the solder processes described above and in the solder process patent application, which also establishes excellent thermal contact of the elongate solar cells to the mounting substrate 901 or heat-sink 903. The use of thin electrically insulating layers allows for good thermal connection between the solar cells and the heat sink without also providing electrical conduction between the elongate cells and the crossbeams or substrate. One such ideal thin electrically insulating layer is an oxide layer grown on the surface of a silicon wafer. The silicon wafer, or a portion of a silicon wafer, is used to transfer heat to the heat sink. The oxide layer can be metallised, with the metal electrically insulated from the wafer substrate by the silicon oxide layer, and the metal surface used to thermally connect the metal electrical conductors of the sheet array to the silicon, preferably using solder, and thus to the heat sink in an electrically insulating manner. Alternatively, the rear surface of the concentrator sheet may have continuous or semi-continuous lines of metallisation running lengthwise along the elongate cells near the centre line of the cells, on top of the solar cell oxide or oxide/nitride passivation stack. This metallisation is connected to the heat sink by solder as described above. The particular advantages of this process include the ease of establishing excellent heat transfer pathways, the ease of ensuring that the thermally conductive pathways are electrically insulating, and the simplicity of providing both electrical and thermal interconnections, via independent pathways, in the same solder process.

Silicon is a highly thermally conductive material. Even when illuminated by concentrated sunlight, it is unnecessary that the whole of one surface of the elongate solar cell or elongate sheet sub-module be directly connected to a heat sink. Heat will conduct laterally across the sheet sub-module assembly, along the length of constituent elongate solar cells to a region where heat sinking is accomplished. In the case where the elongate solar cells are electrically connected edge-to-edge, such as in sheet or concentrator sheet sub-modules, not every elongate solar cell may need to be connected to a heat sink. Heat can flow from one elongate solar cell through the electrical inter-connection to an adjacent elongate solar cell that is thermally attached to the heat sink. In some cases, heat can flow in this manner across several elongate solar cells until a cell that is attached to a heat sink is reached.

Referring to Figure 9, the elongate solar cells 101 are arranged in a sheet array and are mounted on a thermally conductive substrate or heat-sink 901. The substrate 901 is preferably made of silicon or some other highly thermally conducting material having a thermal expansion coefficient substantially compatible with the elongate solar cells 101. Alternatively, the substrate may be a low-expansion metal such as Copal metal, or other low thermal expansion metal. The substrate 901 is bonded to a thermally conducting extrusion 903 having a hollow or cavity 904. A heat exchange fluid (such as air, water, glycol etc.) can be circulated in the cavity at 904. The elongate solar cell sub-system assembly shown in Figure 9 can be used as a sheet-based sub-module assembly micro-receiver in a bifacial solar concentrator system. Such a sub-system may contain any number of elongate solar cells, arranged into sheet arrays of any length, depending upon voltage output requirements.

### Formation of Electrical Connections to Sheets

Elongate solar cell and elongate substrate separation, handling, and assembly complexity can only be simplified using methods that can process relatively large numbers of devices simultaneously. Simultaneous testing, transfer, and assembly is another motivation behind the high-efficiency sheets described herein and the lower efficiency rafts, mesh rafts, and boats described in the rafts patent application. Details of the electrical interconnection methods preferred for sheets and concentrator sheet sub-assemblies, as well as elongated substrate pre-assemblies are provided in the solder process patent application.

Details of tabbing clips, tabbing of the elongate cell and elongate substrate sheets, elongate concentrator sheets, and elongate concentrator substrate sheets, and interconnection methods for sheet-to-sheet electrical connections, and sheet-to-bus bar electrical connections are described below.

Referring to Figure 12, a sheet-to-sheet electrical interconnection clip 1701 electrically and physically interconnects two elongate solar cell sheets. The top surface and the bottom surface of the clip 1701 extend over and under 1801 the electrodes 202 and 203 and a small part of the surface of the elongate solar cell 101 or elongate substrate 101 at the ends of the sheets being electrically joined together. The tabs at the top 1701 and bottom surfaces 1801 serve to locate and retain the two adjoining sheet surfaces, and the section of fingers extending along the direction of the electrodes 202 and 203 serve to draw solder by capillary action to the ends of the fingers of the clip 1701, providing a secure joint along the respective electrodes and between the adjoining sheet sub-modules.

The clips 1701 are stored on an adhesive tape feeder which is fed in to a sheet stringing unit from below, as described below. The clips are shown in more detail in Figure 13, which is a not-to-scale schematic plan view of the sheet-to-sheet electrical interconnection clip 1701 shown in Figure 12. In reality, the clip extends less than 100 µm across the top and under the bottom 1801 of the cell or substrate 141. The electrode is shown as very thick in this schematic - the real thickness is of the order of 2 to 5 µm - and the clip 1701 is of the order of 3 to 5 mm long. The clip is formed by stamping copper shim or foil in a single operation whereby (in this example, four) opposing pairs of parallel cuts are made partly across an elongate rectangular foil in a direction orthogonal to the longitudinal axis of the foil. These cuts define (in this case, ten) corresponding pairs of opposing tabs that are deformed in alternating directions so that the tabs are orthogonal to the original plane of the foil. Once formed, the clips 1701 are then stored in rolls on an adhesive tape surface, in a manner analogous to that used for some electronic devices designed to be fed into pick and place machines. The top surface and the bottom surface of the clip are complementary, enabling stamping in a single operation. In some case the clip can be extended in length and may have more than a single cycle of complementary flaps, corresponding to two flaps on top and two flaps underneath the sheet, (the example shown here is one and a half cycles) extending over and under the electrodes 202 and 203 and a small part of the surface of the elongate solar cell 101 or elongate substrate 101 at the ends of the sheets being electrically joined together. The dotted lines in Figure 13 show the complementary extent of the three tabs (one and a half cycles) at the bottom surfaces of adjoining sheets.

Referring to Figure 14, which is a cross-sectional schematic diagram of a sheet-to-sheet electrical interconnection clip 1701 which is soldered in place and electrically interconnects electrodes 202 and 203. The solder 201 fills the cavity between the clip inner surface and the electrodes, providing good electrical interconnection and also securely attaches the two adjoining sheets in a single physical structure. The top surface and the bottom surface of the clip 1701 extend over and under the electrode in the form of tabs 1801, and a small part of the surface of the elongate solar cell or elongate substrate at the ends of the sheets extends in the form of a narrow finger along the electrode surface of the sheets being electrically joined together. In some implementations of the clip these fingers can be omitted. The tab sections 1801 of the clip 1701 provide no physical strength to the joint, and serve only to assist in the assembly operation, acting as a guide to feed the two adjoining sheets together before the solder operation. The tabs at the top and bottom surfaces serve to locate and retain the two adjoining sheet surfaces prior to soldering, and the section of fingers extending along the direction of the electrode, parallel to and in line with the central vertical section of the clip serve to draw solder by capillary action to the ends of the fingers, providing a more secure joint. The solder 201 is shown filling the cavity between the electrode and the inner surfaces of the clip.

Advantageously, the sheet-to-sheet connector clip can include a flexible section between the two soldered sections abutting the end electrodes of the elongate solar cells or elongate substrates in the sheet sub-module or pre-module respectively. One such arrangement is shown in Figure 15. A flexible section 2001 between the two soldered sections and abutting the end electrodes 202 and 203 respectively of the elongate solar cells or elongate substrates in the sheet sub-module or pre-module serves as a stress relief and expansion joint between elongate sheets strung together in the solar power module. The three-period corrugations of very small amplitude shown in Figure 15 are for illustration purposes only. The actual length, period, and amplitude of the stress relief sections depend on the module materials, the length of the individual sheet sub-assemblies, and the number of sub-assemblies in the row. Other factors influencing the particular design of the connecting clip are the current-carrying capacity requirements of the clip, the amplitude restrictions - depending on whether the application is in a bi-glass module, a bifacial module, a single-glass module with Tedlar backing, a flexible module, or a mini-module application. Furthermore, the thickness of the copper foil is determined by the overall width of the clip, which is restricted by differential expansion considerations along the length of the elongate electrode. These conflicting requirements determine the final clip dimensions. For general bifacial cell encapsulations in a single-glass module, suitable clips have electrode contacts 5 mm long and stress relief sections 2.5 mm long stamped from 45-gauge to 50-gauge shim (British Standard Gauge) which is approximately 70 µm to 25 µm thick (the larger the gauge, the thinner the material in the British system). As shown in plan and cross-sectional side views in Figures 21 and 22, a schematic plan view of a sheet-to-bus bar electrical interconnection clip 2001 is shown, which is finally used at the end of a row or string of elongate sheet solar cells to electrically connect the row to a bus bar of the solar cell module incorporating the sheet sub-module assemblies. The top surface and the bottom surface of the clip 2001 on the side of the last sheet 101 in a row extends over and under the electrode 202 and a small part of the surface of the elongate solar cell 101 or elongate substrate 101 at the end of the sheet, while on the opposite side of the clip 2001 a foot 2002 extends out, shown here pre-tinned with a solder pad 2002, for accepting electrical connection to a bus-bar. The tabs at the top and bottom surfaces of the clip 2001 serve to locate and retain the adjoining surface of the last sheet in the row during the assembly operation: they form no useful purpose, or provide any structural support after soldering is complete. The section of fingers extending along the direction of the electrode serve to draw solder 201 by capillary action to the ends of the fingers, providing a secure joint to the remote sheet electrode surface.

Although the precise configuration of individual connecting clips for any particular application will depend on the requirements described above, the clips provide the following features:
(i) The clip is formed from a single stamping from a foil strip;
(ii) The clip can be easily, cheaply, and reliably delivered to the assembly point on an adhesive tape carrier without the need to locate, pick, or independently place the clip;
(iii) Once the clip is secured between two abutting elongate sheets, the carrier tape can be removed as the clip is self-supporting in the preformed string prior to soldering;
(iv) The connection yoke at either end of the interconnect clip serves as a guide to facilitate location and retention during stringing of the sheet sub-module assemblies;
(v) The solder operation can be performed in a rapid single step, preferably using a no-contact, no pre-heat laser solder method; and
(vi) The integrated stress relief and expansion joint transfers stress away from the fragile elongate cells, preserving the sub-module string integrity.

There is a large design parameter space for adapting the clips to various applications without the requirement for functional re-design. The bus bars (not shown) of a solar cell module are generally made from pre-tinned copper, but can alternatively be made from other metallic materials. Copper is preferred for its high conductivity, and the tinning, which reduces oxidation of the bus-bar surface, is preferably a silver-content solder such a 62/36/2 lead/tin/silver solder. However, alternative forms of solder, including any solder from the lead-free solder range, can be used, and the tinning can include other solders, or other solderable protective and conductive coatings.

The electrical interconnections between the elongate sheets and the connecting clips can be alternatively formed by the application of a conductive material such as colloidal silver paste, electrically conductive epoxy, electrically conductive silicone, electrically conductive inks, or electrically conductive polymers. These materials can be deposited using any one of a variety of techniques, including stencilling, screen-printing, dispensing, pump-printing, ink-jet printing, or stamp-transfer methods, either before or after the clips have been set in place. Alternatively, sheet interconnections can be established with solder and the bus-bar electrical connections established with conductive epoxy. Furthermore, hybrid interconnections can be implemented; for example, by soldering to a conductive epoxy or silver-loaded ink material, or using a conductive compound to connect to a soldered track or joint.

Any of the above techniques, or combination of those techniques, can be used to connect sections of the module or sheet sub-module, or individual elongate cells or elongate substrates or parts of a sheet array, to a bus bar or sheet interconnect clip that electrically interconnects sections of the module.

In an elongate solar cell solar power module, the elongate sheets are directly attached to the bus-bars. Stresses in the various components of the module can be produced by changes in temperature. The coefficients of thermal expansion of crystalline silicon and glass are around 2.5 x 10⁻⁶ °C⁻¹ and 9 x 10⁻⁶ °C⁻¹, respectively. The rates of expansion and contraction of the sliver cells 104 and the substrate 102 are comparable, at least to within a factor of two or three, and can be accommodated by simple stress relief measures. However, polymers such as EVA have coefficients of thermal expansion of the order of ten times greater than glass. Consequently, greater stress relief measures to accommodate the resulting degree of differential thermal expansion need to be undertaken for bi-glass modules, and even greater for single glass modules.

In any case, the coefficient of thermal expansion of the metallic bus bar 108 is substantially larger than those of crystalline silicon and glass, being of the order of 17 x 10⁻⁶ °C⁻¹, and this difference is accommodated by the stress relief measures described above when connecting long sheet rows to long sections of bus bar. Commercial photovoltaic modules are subjected to reliability testing, including thermal cycling over the temperature range of -40 °C to +90 °C, which would result in a total differential excursion of 1.04 mm per metre length of module for a glass substrate and copper bus bar.

Elongate solar cells or elongate substrates in the form of "sheets" as described herein are related to close-spaced rafts or abutting arrays of elongate devices described as boats in the rafts patent application. However, the sheet technology described herein provides a method of assembling and electrically interconnecting elongate solar cells in a high areal efficiency structure, with no additional support structure or materials, and a method for interconnecting adjacent sheets in a reliable, efficient, and easily automated manner.

Furthermore, an efficient and reliable method is described below for testing and binning a plurality of elongate solar cells in a sequential process that can handle of the order of 50, and possibly up to 100 elongate solar cells each cycle. The cycle time can be of the order of 3 to 5 seconds or even shorter with high speed parallel systems for data processing, meaning that elongate solar cell throughput for the single-line test and bin processing module ranges from 10 to 30 elongate devices per second. This is an important number since a full-scale 100 MWp manufacturing facility will need to process of the order of 150 to 200 elongate solar cells per second. Speed, efficiency, reliability, and a simple, effective process for testing and binning are key elements in the commercial manufacturability of elongate solar cell technology. Furthermore, the entire process line, including input and output functions, is very compact and can easily be installed in an area the size of an office. A gang of ten such machines would require only five shared input and output services and could, with a sufficient margin of redundancy for reliability, service a 100 MWp manufacturing facility.

Referring to Figure 19, a vacuum 2204 pick-up head 2203 extracts a planar array composed of correctly-oriented, correctly-spaced elongate solar cells 101 from an array of buffer storage receptacles or cassettes 2201 such as those described in the rafts patent application. Figure 20 shows plan and cross sectional views of a section of a single stack cassette or a single stack from a multi-stack cassette. The method of retaining and singulating slivers extracted from the device is illustrated. As described in the rafts patent application, this method relies on the inherent flexibility of this form of elongate solar cells or elongate substrates.

The number of single-stack cassettes or bulk single-stack device storage units is preferably equal to one-on-n of the number of devices required to form a sheet or concentrator sheet sub-module. In this case, the integer 'n' divides with no remainder into the total number of devices in the sub-module, resulting in the sub-module array being constructed using 'n' repeated separation and assembly operations from single or grouped single stack cassettes, and each successive placement being offset by the width of a device plus a space corresponding to the thickness of the electrical interconnection.

Alternatively, the cells may be extracted from a multi-stack cassette with the desired stack spacing. The pitch of (*i.e*., spacing between) the stacks is selected according to the required device location spacing or pitch in the final sheet or concentrator sheet unit. The planar array of cells is presented to a multi-station test-bed such as that shown in Figure 21. It may be advantageous to conduct this entire operation in an "upside-down" fashion. For example, the device array is extracted from the base of the cassette array where the device stack in each array stack is secured by a weight rather than by a spring as shown. A similar principle applies to the assembly section, as well as the separation and buffer storage and the loading of the cassettes. This approach is covered in detail in the rafts patent application.

Preferably, the light source 2302 for the test station is a "daylight" LED array with the LED mix chosen to provide a spectrum close to the Global AM1.5 solar spectrum. Alternatively, the solar cell response can be calibrated to the source spectrum using reference cells. Similarly, the light source may be a commercial Xenon flash unit, which is cheap and reliable and has a long lifetime. A third option is a quartz-halogen source, but these also generate a lot of waste heat, which can be a problem when testing high efficiency solar cells with very low thermal mass.

The array of elongate solar cells 101 transported and presented by the vacuum head 2203 engage an array of current and voltage contacts 2301. An IV curve for each elongate solar cell is acquired. This can be done quite rapidly for calibrated production as only a very few data points are required in order to establish the open circuit voltage, short circuit current and maximum power point in order to qualify the elongate cell performance and thereby determine the particular bin for the cell.

The vacuum transfer head 2203 carrying the array of tested and qualified elongate solar cells 101 moves to the first "bin", shown in Figure 22, comprised of an array of single stack storage cassettes 2401. Elongate solar cells with performance parameters matching the requirements for this bin are individually, and simultaneously, retained in the respective single stack storage cassette. For example, the left-most stack in Figure 22 has significantly more tested and sorted elongate solar cells than the adjacent single-stack cassette. The control system for the test and binning module records the number of individual devices placed in each single-stack cassette 2401 station. When a particular single-stack cassette is full, it is removed and replaced with an empty single stack storage device during the period of the cycle when the vacuum head 2203 is clear of the stack array.

The cycle continues, with the vacuum head 2203 and partially depleted array of elongate solar cells progressing to the next performance bin and array of elongate solar cell single-stack cassettes. The elongate solar cells with performance parameters matching the requirements for this bin are individually, and simultaneously, retained in the respective single stack storage cassette. For example, the left-most stack of the right hand bin single-stack cassette array in Figure 22 has significantly fewer tested and sorted elongate solar cells than the adjacent single-stack cassette on the right. The control system for the test and binning module records the number of individual devices placed in each single-stack cassette 2401 of each performance bin station. When a particular single-stack cassette is full, it is removed and replaced with an empty single stack storage device during the period of the cycle when the vacuum head 2203 is clear of the stack array.

The cycle continues, with the sequence of vacuum heads 2203 progressing along the process line of the test-and-bin module with the following events occurring at each process cycle:
(i) The process cycle is arbitrarily defined to "start" as each vacuum head in the sequence commences motion in a particular direction (in the described embodiment, to the right);
(ii) At the start of the cycle, a fresh head approaches from the left and is positioned above the array of single stack cassettes containing untested elongate solar cells;
(iii) At the start of the cycle, a vacuum head in the linear sequence that has not yet completed its pickup-test-sort-deposit sequence (in which case the vacuum head is hereinafter defined as "active"), and is not in motion back to the start of the line (in which case the vacuum head is hereinafter defined as "inactive"), simultaneously moves one station to the right as this fresh, newly "active" head moves in from the left;
(iv) Each head in the sequence that is active moves downward to the respective elongate solar cell array pick-up from the array of single stack cassettes, or the elongate solar cell test station, or the particular array of single stack cassettes forming a performance bin that lies beneath the respective vacuum head;
(v) The respective elongate solar cell array pick-up, elongate solar cell array test, elongate solar cell transfer to performance bin single stack cassettes action is executed;
(vi) Each head in the sequence that is active moves upward to the park position above the respective elongate solar cell array pick-up from the array of single stack cassettes, or the elongate solar cell test station, or the particular array of single stack cassettes forming a performance bin that lies beneath the respective vacuum head where the previous action has been executed; and
(vii) The process cycle is complete, and subject to certain interlocks and system integrity checks, will be repeated to process further elongate solar cells.

Within the above global cycle there are several smaller cycles involving the removal of full tested and sorted single-stack cassettes and subsequent (off-line) transfer to appropriate storage locations; the replacement of removed full single-stack storage cassettes with empty single-stack storage cassettes into test bin arrays; the removal of empty multi-stack cassettes and replacement with multi-stack cassettes full of elongate solar cells ready to test.

Each of the above small-cycle functions are performed simultaneously at the part of the global cycle during which the array of vacuum heads are rising to the park position and moving along the line to a subsequent park position in a single synchronous event slot. Each of the replenishment or removal operations involves a simple, one-dimensional sideways movement of the feed or store device, preferably actuated by the replacement device, in a single synchronous linear motion on each device separately. The feed or store device that has been removed from the line can be transferred asynchronously to their respective destinations. There is adequate time for transfer of removed cassettes and replenishment with new cassettes waiting to be introduced to the line. Each cassette holds of the order one thousand to several thousand, but could be adapted to hold many thousand elongate solar cells in each stack. At a transfer rate of one cell every three to five seconds a storage or supply device requires infrequent handling.

Advantageously, the throughput of elongate solar cells in the test, sort, and bin process line module is a function of very strong parallelisms. It is very little more trouble to pick up an array of two cells than it is to pick up a single cell. Furthermore, all the functions of pick-up, test, sort, transfer, and bin can be performed in parallel with zero time penalty or wasted process line motion. A yet further advantage is that the performance-binned cells are placed in buffer storage in single-stack cassettes that can be used to form any desired elongate solar cell array sub-module assembly, including rafts, mesh rafts, boats, sheets and concentrator sheets with no intermediate handling.

For smaller sub-module devices where the individual sub-module efficiency is of reduced importance, the performance of individual elongate solar cells is also of reduced importance. However, for high performance sheet sub-module assemblies incorporating many more cells, and where high efficiency requirements demand well-matched cells, the method described above provides a cheap, fast, efficient, and effective means of providing a large range of well-matched cells in as fine a performance array grid as required.

It is important to note here one of the key advantageous attributes of this test and bin method: this is that, just as it is of negligible further process cost to add another elongate solar cell to the array of cells being transported, tested, and binned, it is also of negligible process cost to add an additional test bin category. Additional bins require additional vacuum heads, control system and data recording, but do not add to the individual step process time or the lapsed time for a complete global cycle. Therefore, reducing granularity of the performance binning by add adding extra performance categories and thus increasing yield and module performance comes at absolutely no throughput expense.

### Elongate Sheet Sub-module and Pre-module Formation

A vacuum 2204 pick-up head 2203 extracts a planar array composed of correctly-oriented, correctly-spaced elongate solar cells 101 from an array of buffer single-stack storage cassettes 2401. Further details of methods and processes for handling and processing elongate substrates and solar cells are provided in the rafts patent application. The particular methods described in that application include methods for assembling elongate solar cells into particular forms of assemblies respectively referred to as rafts, mesh rafts, and boats. Those methods are readily adaptable to the formation of elongate solar cell sheet sub-modules and elongate substrate sheet pre-modules by adapting the methods for zero-spaced assemblies and assemblies with no additional structural members.

Additional details for the design of elongate sheets, and the method of separation, handling, and assembly of elongate devices to form elongate solar cell sheets, elongate solar cell concentrator sheets, and elongate substrate sheets, and the design of electrical interconnections within and between elongate solar cell sheets and within and between elongate substrate sheets, and a method for establishing electrical interconnections between adjacent elongate solar cells in an elongate solar cell sheet and between elongate substrates in an elongate substrate sheet pre-module, and contain the elongate devices in an array in the absence of a wafer frame are described herein.

Methods for assembling and electrically interconnecting the elongate "sheet" assemblies described above for confining elongate solar cells and elongate substrates in contiguous arrays or partially contiguous arrays of elongate solar cells or elongate substrates in the absence of additional supporting members or constructs other than the basic electrical interconnection material are described below.

Elongate solar cells or elongate substrate devices in the form of "sheets" are related to close-spaced "rafts" or abutting arrays of elongate devices described as "boats" in the rafts patent application. However, the sheet technology described herein provides a method of assembling and electrically interconnecting tested, graded, and binned elongate solar cells in a high areal efficiency structure, with no additional support structure or materials, and an method for interconnecting adjacent sheets in a reliable, efficient, and easily automated manner.

Furthermore, described herein is an efficient and reliable method for extracting an array of tested and binned elongate solar cells, assembling an array or plurality of tested and binned elongate solar cells in a sequential process that can handle of the order of 50, and possibly up to 100 or more elongate solar cells each cycle. The cycle time can be of the order of 3 to 5 seconds, or may be even shorter with high-speed systems. However, as with the test method described above, the high throughput, as measured by the number of elongate solar cells, or completed sheets output per time interval, is achieved by very cost effective parallelisms in the handling and assembly procedures, rather than focussing on the speed of each operation. The "parallel handling concept" achieves elongate solar cell throughput for the "bulk pick and place" extraction and assembly and electrical interconnection processing stages of sub-module sheet production in the range from 10 to 30 elongate devices per second. As previously mentioned, this is an important number since a full-scale 100 MWp manufacturing facility will need to process of the order of 150 to 200 elongate solar cells per second.

"Bulk" or "parallel" handling and processing has been the theme and guiding principle behind the developments in elongate solar cell separation, handling, storage, testing, binning, array assembly, electrical interconnection, stringing, and solar power module assembly based on elongate solar cells described herein. Manufacture and assembly of elongate solar power modules involves the production, processing, and assembly of a large number of very low cost devices, whereas the manufacture and assembly of conventional solar power modules involves the production, processing, and assembly of a small number of relatively expensive devices. The speed, efficiency, and reliability of the methods and processes described herein are a function of parallel throughput process-line channels using simple and cheap processes and equipment, designed for simple, reliable, long-term operation rather than expensive, very fast, high maintenance, high-tech equipment. In many cases, line elements or process modules, such as separation and device storage, and also some elements of the assembly process, can be reliably and simply operated by hand. It is much more effective to engage and move 100 elongate solar cells in a single operation per second, than to try to engage and move individual elongate solar cells in 10 ms per operation.

Referring to Figure 23, a vacuum 2204 pick-up head 2203 extracts a planar array composed of correctly-oriented, correctly-spaced elongate solar cells 101 from an array of buffer single-stack storage cassettes 2401. Alternatively, the cells 101 can be extracted from a multi-stack cassette with the desired inter-stack spacing. The planar array of cells is presented to and engaged by an assembly jig 2701 which incorporates a vacuum array (not shown) to maintain the orientation and relative locations of the presented array of elongate solar cells.

Alternatively, and preferably, as shown in Figure 28, the presented array 100 of elongate solar cells 101 is retained in place by the retaining members 3402 of a clamp 3400. Each retaining member 3402 is attached to the base 3404 of the clamp 3400 by arms 3406 mounted on hinges 3408 so that the retaining members 3402 can be rotated into place to engage the top surfaces of the elongate solar cells 101 after the latter have been placed on the clamp base 3404. In an alternative clamp, two retaining members with interleaving projections or fingers are provided at each end of the clamp, so that the mutually spaced fingers of the first retaining member hold down a first presented, double-spaced array of elongate solar cells 101, and the mutually spaced fingers of the second retaining member, interleaved with the fingers of the first retaining member, hold down a second presented array section. This arrangement is duplicated for both ends of the elongate solar cells in the array. In the case where the sheet array is assembled in three steps, a similar arrangement, with three retaining members with interleaving projections or fingers at each end of a clamp, and three assembly stages, with each stage assembling every third cell in the array proceeds in the same manner.

Referring to Figure 24, which is the second part of a two-stage, double-spaced single-stack array or multi-stack double-spaced array assembly operation. The second half-array, which fills the odd spaces left from the first half-array deposited on the assembly jig is extracted from the cassette array by vacuum head 2203 and placed on the assembly jig 2701. The vacuum retention, or preferably the swinging retaining members 3402 described above retain the second half, odd-spaced array. The spacing between the edge electrodes, measured as a clearance space after all assembly and process tolerances are accounted for, is selected to provide clearance between the elongate cells and to allow space for the electrical interconnection, of the order of 5 µm to 20 µm, preferably applied by a selective wave solder process 3001 as described above. In the case of elongate solar cells with pre-tinned electrodes, the spacing, again measured after all process and placement tolerances are accounted for, between the devices is smaller, of the order of 5 µm to 10 µm, and the electrical interconnections are accomplished by sweating the adjacent devices together in a reflow operation.

The sheet devices are transported by the same assembly jigs regardless of whether a selective wave solder or a reflow operation is used to establish electrical interconnections. The assembly jigs are transported on a conveyor which rotates through an angle of 180° about an axis in the direction of conveyor travel so that the jig assemblies are inverted to pass through the selective wave solder fountain 3001, as shown schematically in Figure 25.

Following the establishment of electrical interconnections, the sheet solar cell sub-module assemblies, or sheet substrate assemblies are structurally complete and are stored ready for delivery to the next stage of processing in a sheet stack cassette, as shown in Figure 26. The sheet "de-stacking" mechanism from this sheet cassette 3101 is simply a wider variation of the single elongate device de-stacker 2201 described in the rafts patent application and shown in Figure 20, and relies on the inherent flexibility of elongate solar cells and elongate substrates for the simplicity and reliability of its operation.

In the case of elongate substrate sheets, (*i.e.*, substrates that have not yet been processed to form functioning solar cells therein) the next stage is the first step of low temperature cell processing. In the case of elongate solar cell sheets, the next step is the assembling and electrical interconnection of adjacent elongate solar cell sheet sub-module assemblies into serial- and or parallel-connected rows along with bus-bar attachments ready for encapsulation into a solar power module.

Referring to Figure 27, the sheet de-stacker drops an elongate solar cell sheet onto a conveyor. If the sheet is the first in a row of sheets then a sheet to bus-bar connector is fed on adhesive tape over the second roller and the sheet is guided into the clip. The clip is peeled off the tape by forward motion of the sheet until the rear edge of the sheet is in position for a sheet to sheet connector clip. At this stage, the clip is in position for the laser solder operation. Simultaneously, a second sheet is de-stacked, dropped to the conveyor, and when the solder process is complete, moves forward to engage the clip, which is removed from the adhesive tape and pushed onto the rear edge of the first sheet. The process cycle continues until the desired length of sheets is obtained, at which stage the sheet row is terminated with a sheet to bus-bar connector. The row string is moved to the module lay-up area and prepared for connection to bus bars and final lay-up in preparation for encapsulation.

The sheet row assembly process line uses an adaptation of conventional cell handling and processes and an adaptation of elongate sheet handling methods. The process is completely flexible, and any combination of series and parallel interconnections can be formed. For example, every second series-connected row of sheets can have a parallel interconnection to adjacent series rows simply by using two sheet to bus-bar interconnectors back to back instead of the normal sheet to sheet connector, with the common bus-bar connection connected to the corresponding location on the adjacent series-connected row of sheets. In this way, every sheet connected in series in a row (or "string") is also connected in parallel to the corresponding sheets in adjacent rows (or "strings") of sheets.

Although the electrical interconnection and assembly processes have been described herein in terms of a particular form of assembly referred to herein as a "sheet" assembly or sub-module, it will be apparent to those skilled in the art that these processes can also be applied to other forms of elongate substrate or solar cell assembly, some of which are described in the rafts patent application. Further, the processes described herein provide the means for fabricating elongate solar cell solder sheet sub-module assemblies, elongate substrate solder sheet pre-module assemblies, and elongate solar cell solder concentrator sheets; the properties of which are described above.

In particular, the processes described herein allow the assembly, electrical connectivity, and means of establishing the physical structure of a plurality of elongate solar cells to form a high areal efficiency sub-assembly with a significant reduction in the number of steps compared to those required for present state of the art sliver or plank elongate solar cell assembly, and without the introduction or use of any adhesives or non-standard materials into the assembly and hence subsequently into the solar power module.

The methods, structure, and processes described herein maintain the orientation and polarity of sliver solar cells during assembly, provide significant simplification of the sliver solar cell assembly handling and processing, subsequent photovoltaic module assembly processes, produce easily handled solder sheet sub-modules with a greatly reduced number of individual assembly and processing steps required, allows the easy use of conventional photovoltaic module assembly equipment for handling and stringing elongate solar cell solder sheets, and allow the use of solely conventional photovoltaic module materials in manufacturing sliver solar cell modules and narrow-cell solar modules.

## Claims

1. A substrate assembly (100) for a photovoltaic device, the assembly (100) including an array of elongate semiconductor substrates (101), each of the elongate substrates (101) having opposite faces (506) bounded by longitudinal edges, the elongate substrates (101) being electrically interconnected and maintained in a longitudinally parallel arrangement by an electrically conductive material (102; 202; 203; 301; 401; 502; 503; 601 ;701) disposed between the opposing longitudinal edges of adjacent ones of said elongate substrates (101) **characterised in that** the opposite faces of each elongate substrate (101) remain entirely exposed between the electrically conductive material (102; 202; 203; 301; 401; 502; 503; 601;701).

2. An assembly (100) as claimed in claim 1, wherein said elongate substrates (101) include solar cells so that at least one of the opposing faces of each elongate substrate (101) is adapted to generate electrical current when exposed to light.

3. An assembly (100) as claimed in claim 2, wherein both of the opposing faces of each elongate substrate are adapted to generate electrical current when exposed to light.

4. An assembly (100) as claimed in claim 1, wherein the electrically conductive material (102; 202; 203; 301; 401; 502; 503; 601 ;701) is selected for compatibility with subsequent processing to form solar cells in said elongate substrates.

5. An assembly (100) as claimed in any one of claims 1 to 4, wherein the spacing between opposing longitudinal edges of said elongate substrates (101) is less than about 3mm.

6. An assembly (100) as claimed in claim 5, wherein the spacing between opposing longitudinal edges of said elongate substrates (101) is at most about 3µm.

7. An assembly (100) as claimed in any one of claims 1 to 6, wherein the opposing longitudinal edges of said elongate substrates (101) are in substantial abutment.

8. An assembly (100) as claimed in any one of claims 1 to 7, wherein the assembly (100) is substantially planar.

9. An assembly (100) as claimed in any one of claims 1 to 7, wherein the assembly (100) is curved.

10. An assembly (100) as claimed in claim 9, wherein the assembly (100) is conformally mounted to a curved and substantially rigid support.

11. An assembly (100) as claimed in claim 10, wherein the curved and substantially rigid support is transparent.

12. An assembly (100) as claimed in any one of claims 1 to 7, wherein the assembly is flexible.

13. An assembly (100) as claimed in any one of claims 1 to 12, wherein the longitudinal edges of each elongate substrate (101) include a p-type (202;502) edge and an n-type (203;503) edge, the electrically conductive material connecting the p-type (202;502) edge of each elongate substrate (101) to the n-type (203;503) edge of an adjacent elongate substrate (101).

14. An assembly (100) as claimed in any one of claims 1 to 13, wherein the electrically conductive material disposed between adjacent elongate substrates (101) does not extend beyond the faces of the elongate substrates (101).

15. An assembly (100) as claimed in any one of claims 1 to 13, wherein the electrically conductive material disposed between adjacent elongate substrates (101) extends beyond the faces of the elongate substrates (101) to allow the assembly to be attached to a support or heat sink (903).

16. An assembly (100) as claimed in any one of claims 1 to 15, wherein the electrically conductive material is disposed substantially along the entirety of each longitudinal edge.

17. An assembly (100) as claimed in any one of claims 1 to 15, wherein the electrically conductive material is disposed at mutually spaced locations along the each longitudinal edge.

18. An assembly (100) as claimed in any one of claims 1 to 17, wherein each elongate substrate (101) includes electrical contacts on its longitudinal edges, a portion of each electrical contact extending partially over one face of the elongate substrate (101).

19. An assembly (100) as claimed in claim 18, wherein the electrically conductive material disposed between longitudinal edges of adjacent ones of said elongate substrates (101) extends over the extending portion of each electrical contact to allow the assembly to be attached to a support or heat sink (903).

20. An assembly (100) as claimed in any one of claims 1 to 19, wherein each elongate substrate (101) includes at least one electrical pathway over one face of the elongate substrate (101) to connect an electrical contact on one longitudinal edge of the elongate substrate (101) to an electrical contact of the same polarity on the opposite longitudinal edge of the elongate substrate (101), the at least one electrical pathway being electrically insulated from the face of the elongate substrate (101).

21. An assembly (100) as claimed in claim 20, wherein the polarity of the connected electrical contacts is n-type.

22. An assembly (100) as claimed in any one of claims 1 to 21, including electrical pathways on one face of the assembly (100), the other face of the assembly (100) being substantially entirely exposed and free of electrical connections to facilitate the generation of electrical current when said other face is exposed to light.

23. An assembly (100) as claimed in claim 22, wherein the electrical pathways are substantially orthogonal to the longitudinal edges of the elongate substrates (100).

24. An assembly (100) as claimed in any one of claims 1 to 23, wherein at least one of the opposing faces of each elongate substrate (101) is entirely exposed.

25. An assembly (100) as claimed in any one of claims 1 to 24, wherein said electrically conductive material includes solder.

26. An assembly (100) as claimed in any one of claims 1 to 24, wherein said electrically conductive material is a polymer.

27. An assembly (100) as claimed in any one of claims 1 to 26, wherein a largest physical dimension of the assembly (100) is substantially equal to a diameter of a standard semiconductor wafer.

28. An assembly (100) as claimed in any one of claims 1 to 27, wherein the elongate substrates (101) are formed by a sliver process.

29. An assembly (100) as claimed in any one of claims 1 to 27, wherein the elongate substrates (101) are formed by dividing semiconductor wafers into elongate portions, the faces of the elongate substrates being formed from corresponding portions of a surface of each semiconductor wafer.

30. A substrate assembly (100) including a plurality of assemblies (100) as claimed in any one of claims 1 to 29, said assemblies (100) being mutually attached and electrically interconnected by elongate connectors disposed between corresponding adjacent ones of said assemblies (100), each of said elongate connectors being longitudinally parallel to said assemblies (100) and having locating portions that engage opposing faces of each adjacent elongate substrate (101) assembly, said connectors being attached and electrically connected to said assemblies (100) by an electrically conductive material disposed between said connectors and longitudinal edges of said elongate substrates (101).

31. An assembly (100) as claimed in claim 30, wherein the locating portions of each elongate connector include first locating portions that engage a first adjacent elongate substrate assembly, and second locating portions that engage a second adjacent elongate substrate assembly (100), the elongate connector including a stress relief portion disposed between said first locating portions and said second locating portions, said stress relief portion defining an indirect path between said locating portions and said second locating portions to accommodate thermal expansion and thereby maintain connection between the adjacent elongate substrate assemblies (100).

32. A substrate assembly (100) as claimed in claim 30 or 31, wherein the elongate connectors are formed from copper foil.

33. An assembly (100) as claimed in any one of claims 1 to 32, including a bus bar connector for electrically connecting said assembly to a bus bar, said bus bar connector including locating portions that engage opposing faces of an outermost one of said elongate substrates (101), said bus bar connector being attached and electrically connected to said assemblies (101) by an electrically conductive material disposed between said bus bar connector and a longitudinal edge of said outermost one of said elongate substrates (101).

34. An assembly (100) as claimed in claim 33, wherein said bus bar connector includes a contact portion extending away from the substrate assembly (100) attached to said bus bar connector to facilitate connection to said bus bar.

35. An assembly (100) as claimed in claim 34, wherein the bus bar connector includes a stress relief portion (2001) defining an indirect path between said contact portion and said locating portions to accommodate thermal expansion and thereby maintain electrical connection between said assembly (100) and said bus bar.

36. A solar power module including a plurality of substrate assemblies (100) as claimed in any one of claims 1 to 35.

37. A photovoltaic device including a plurality of substrate assemblies (100) as claimed in any one of claims 1 to 35.

38. A linear concentrator receiver, including a plurality of substrate assemblies (100) as claimed in any one of claims 1 to 35, the substrate assemblies (100) being arranged in one or more rows, each row including a plurality of said substrate assemblies (100) in substantial abutment.

39. A linear concentrator receiver, including a plurality of substrate assemblies (100) as claimed in any one of claims 1 to 35, the substrate assemblies (100) being arranged in rows, each row including a plurality of said substrate assemblies in substantial abutment and electrically interconnected in series, at least some of the rows being electrically interconnected in parallel.

40. A linear concentrator receiver as claimed in claim 38 or 39, wherein the elongate substrates (101) are electrically connected in series so that the electrical current generated by the elongate substrates (101) flows substantially in a direction parallel to the longitudinal axis of the linear concentrator system to reduce the series resistance of the elongate substrates (101).

41. A linear concentrator receiver as claimed in claim 39 or 40, wherein the substrate assemblies (100) are curved to reduce cosine losses in the receiver.

42. A linear concentrator receiver as claimed in any one of claims 38 to 41, wherein the longitudinal edges of the substrate assemblies (100) are orthogonal to a longitudinal axis of the linear concentrator receiver.

43. A substrate assembly process, including forming a substrate assembly (100) for a photovoltaic device by depositing an electrically conductive material (102; 202; 203; 301; 401; 502; 503; 601 ;701) between opposing longitudinal edges of adjacent elongate semiconductor substrates (101) to electrically interconnect said elongate substrates (101) and maintain said elongate substrates (101) in a longitudinally parallel arrangement, the electrically conductive material being deposited **characterised in that** opposing faces of each elongate substrate (101) remain substantially entirely exposed between the electrically conductive material (102; 202; 203; 301; 401; 502; 503; 601;701).

44. A process as claimed in claim 43, wherein at least one of said opposing faces of each elongate substrate (101) is adapted to generate electrical current when exposed to light.

45. A process as claimed in claim 43, including forming solar cells in said elongate substrates (101) so that at least one of said opposing faces is adapted to generate electrical current when exposed to light.

46. A process as claimed in claim 45, wherein the electrically conductive material is selected for compatibility with subsequent processing to form said solar cells.

47. A process as claimed in any one of claims 43 to 47, wherein the longitudinal edges of said elongate substrates (101) are maintained in substantial abutment.

48. A process as claimed in any one of claims 43 to 47, wherein said assembly is substantially planar.

49. A process as claimed in any one of claims 43 to 47, wherein the assembly is curved.

50. A process as claimed in any one of claims 43 to 49, including conformally mounting the assembly (100) to a curved and substantially rigid support.

51. A process as claimed in any one of claims 43 to 50, including arranging said elongate substrates (101) into a curved arrangement prior to said depositing, the step of depositing causing the curved arrangement to become substantially planar.

52. A process as claimed in any one of claims 43 to 51, including forming an anti-reflection or reflective coating on the assembly (100) after the electrically conductive material (102; 202; 203; 301; 401; 502; 503; 601 ;701) has been deposited.

53. A process as claimed in any one of claims 43 to 13, wherein the electrically conductive material (102; 202; 203; 301; 401; 502; 503; 601 ;701) disposed between adjacent elongate substrates (101) includes protruding portions (701) extending beyond the faces of the elongate substrates (101); the process including mounting the assembly to a support or heat sink (903) at the protruding portions (701).

54. A process as claimed in any one of claims 43 to 53, including forming at least one electrical pathway over one face of each elongate substrate (101) to connect an electrical contact on one longitudinal edge of the elongate substrate (101) to an electrical contact of the same polarity on the opposite longitudinal edge of the elongate substrate (101).

55. A process as claimed in any one of claims 43 to 54, including forming electrical connections on one face of the assembly (100), the other face of the assembly (100) being substantially entirely exposed and free of electrical connections to facilitate the generation of electrical current when said other face is exposed to light.

56. A process as claimed in claim 55, including mounting the assembly (100) on a support having a surface with recessed regions therein, the electrical connections on the face of the assembly (100) being received in said recessed regions.

57. A process as claimed in any one of claims 43 to 56, wherein said electrically conductive material (102; 202; 203; 301; 401; 502; 503; 601 ;701) is a polymer so that the substrate assembly (100) is flexible.

58. A process as claimed in any one of claims 43 to 56, wherein the electrically conductive material (102; 202; 203; 301; 401; 502; 503; 601 ;701) is deposited by a solder wave process.

59. A process as claimed in any one of claims 43 to 58, including attaching elongate connectors between corresponding adjacent ones of a plurality of substrate assemblies (100) formed by a process as claimed in any one of claims 43 to 58, each of said elongate connectors being attached longitudinally parallel to said assemblies and having locating portions that engage opposing faces of each adjacent elongate substrate (100) assembly; and introducing an electrically conductive material (102; 202; 203; 301; 401; 502; 503; 601 ;701) between said connectors and longitudinal edges of said elongate substrates to mechanically and electrically interconnect said assemblies (101).

60. A process as claimed in claim 59, wherein the electrically conductive material (102; 202; 203; 301; 401; 502; 503; 601 ;701) is introduced between said connectors and said longitudinal edges of said elongate substrates (101) using a contact-less soldering process.

61. A process as claimed in any one of claims 43 to 60, including attaching a bus bar connector to a substrate assembly (100) formed by a process as claimed in any one of claims 43 to 58 to electrically connect said assembly to a bus bar, said bus bar connector including locating portions that engage opposing faces of an outermost one of said elongate substrates (101); and introducing an electrically conductive material (102; 202; 203; 301; 401; 502; 503; 601 ;701) between said bus bar connector and a longitudinal edge of said elongate substrate (101) to mechanically and electrically interconnect said assembly to said bus bar connector.

62. A process as claimed in claim 61, wherein the electrically conductive material (102; 202; 203; 301; 401; 502; 503; 601 ;701) is introduced between said bus bar connector and said longitudinal edge of said elongate substrate (101) using a contact-less soldering process.

63. A process as claimed in any one of claims 43 to 62, including forming one or more rows of substrate assemblies (100) formed by a process as claimed in any one of claims 43 to 58, each row including a plurality of said substrate assemblies (100) in substantial abutment; and mounting said one or more rows in a linear concentrator receiver so that the longitudinal edges of the substrate assemblies (100) are orthogonal to a longitudinal axis of the linear concentrator receiver.

64. A process as claimed in claim 63, wherein a plurality of rows of said assemblies are mounted in said linear concentrator receiver, and the process includes electrically interconnecting at least some of the rows in parallel.

65. A process as claimed in claim 63 or 64, including curving the substrate assemblies (100) to reduce cosine losses in the linear concentrator receiver.

66. A substrate assembly produced by a process as claimed in any one of claims 43 to 62.

67. A linear concentrator receiver produced by a process as claimed in any one of claims 63 to 65.

68. A substrate assembly apparatus having components for executing the steps of any one of claims 43 to 65.

## Patentansprüche

1. Substrat-Bauteil (100) für eine Photovoltaik-Vorrichtung, wobei das Bauteil (100) eine Anordnung an länglichen Halbleiter-Substraten (101) aufweist, wobei jedes der länglichen Substrate (101) gegenüberliegende Flächen (506) aufweist, die von Längskanten begrenzt sind, wobei die länglichen Substrate (101) elektrisch miteinander verbunden und in einer längslaufend parallelen Anordnung durch ein elektrisch leitfähiges Material (102; 202; 203; 301; 401; 502; 503; 601; 701) gehalten sind, das zwischen den gegenüberliegenden Längskanten von benachbarten Substraten der besagten länglichen Substrate (101) angeordnet ist, **dadurch gekennzeichnet, dass** die gegenüberliegenden Flächen eines jeden länglichen Substrats (101) gänzlich zwischen dem elektrisch leitfähigen Material (102; 202; 203; 301; 401; 502; 503; 601; 701) freigelegt bleiben.

2. Bauteil (100) nach Anspruch 1, wobei die besagten länglichen Substrate (101) Solarzellen aufweisen, so dass mindestens eine der gegenüberliegenden Flächen eines jeden länglichen Substrats (101) so angepasst ist, dass sie elektrischen Strom erzeugt, wenn sie Licht ausgesetzt ist.

3. Bauteil (100) nach Anspruch 2, wobei beide der gegenüberliegenden Flächen eines jeden länglichen Substrats so angepasst sind, dass sie elektrischen Strom erzeugen, wenn sie Licht ausgesetzt sind.

4. Bauteil (100) nach Anspruch 1, wobei das elektrisch leitfähige Material (102; 202; 203; 301; 401; 502; 503; 601; 701) so ausgewählt wird, dass es kompatibel mit einer Weiterverarbeitung zur Bildung von Solarzellen in besagten länglichen Substraten ist.

5. Bauteil (100) nach einem der Ansprüche 1 bis 4, wobei der Abstand zwischen gegenüberliegenden Längskanten der besagten länglichen Substrate (101) weniger als ungefähr 3mm beträgt.

6. Bauteil (100) nach Anspruch 5, wobei der Abstand zwischen gegenüberliegenden Längskanten der besagten länglichen Substrate (101) höchstens ungefähr 3µm beträgt.

7. Bauteil (100) nach einem der Ansprüche 1 bis 6, wobei die gegenüberliegenden Längskanten der besagten länglichen Substrate (101) im Wesentlichen aneinandergrenzen.

8. Bauteil (100) nach einem der Ansprüche 1 bis 7, wobei das Bauteil (100) im Wesentlichen flach ist.

9. Bauteil (100) nach einem der Ansprüche 1 bis 7, wobei das Bauteil (100) gewölbt ist.

10. Bauteil (100) nach Anspruch 9, wobei das Bauteil (100) konform an einem gewölbten und im Wesentlichen steifen Auflager angebracht ist.

11. Bauteil (100) nach Anspruch 10, wobei das gewölbte und im Wesentlichen steife Auflager transparent ist.

12. Bauteil (100) nach einem der Ansprüche 1 bis 7, wobei das Bauteil flexibel ist.

13. Bauteil (100) nach einem der Ansprüche 1 bis 12, wobei die Längskanten eines jeden länglichen Substrats (101) eine p-leitende (202; 502) Kante und eine n-leitende (203;503) Kante aufweisen, wobei das elektrisch leitfähige Material die p-leitende (202; 502) Kante eines jeden länglichen Substrats (101) mit der n-leitenden (203; 503) Kante eines benachbarten länglichen Substrats (101) verbindet.

14. Bauteil (100) nach einem der Ansprüche 1 bis 13, wobei sich das elektrisch leitfähige Material, das zwischen benachbarten länglichen Substraten (101) angeordnet ist, nicht über die Flächen der länglichen Substrate (101) hinaus erstreckt.

15. Bauteil (100) nach einem der Ansprüche 1 bis 13, wobei sich das elektrisch leitfähige Material, das zwischen benachbarten länglichen Substraten (101) angeordnet ist, über die Flächen der länglichen Substrate (101) hinaus erstreckt, so dass das Bauteil an einem Auflager oder einem Kühlkörper (903) angebracht werden kann.

16. Bauteil (100) nach einem der Ansprüche 1 bis 15, wobei das elektrisch leitfähige Material im Wesentlichen entlang der ganzen Länge einer jeden Längskante angeordnet ist.

17. Bauteil (100) nach einem der Ansprüche 1 bis 15, wobei das elektrisch leitfähige Material an voneinander beabstandeten Positionen entlang jeder Längskante angeordnet ist.

18. Bauteil (100) nach einem der Ansprüche 1 bis 17, wobei jedes längliche Substrat (101) elektrische Kontakte auf seinen Längskanten aufweist, wobei sich ein Teil eines jeden elektrischen Kontakts teilweise über eine Fläche des länglichen Substrats (101) erstreckt.

19. Bauteil (100) nach Anspruch 18, wobei sich das elektrisch leitfähige Material, das zwischen den Längskanten von benachbarten der besagten länglichen Substrate (101) angeordnet ist, über den sich erstreckenden Teil eines jeden elektrischen Kontakts hinaus erstreckt, so dass das Bauteil an einem Auflager oder einem Kühlkörper (903) angebracht werden kann.

20. Bauteil (100) nach einem der Ansprüche 1 bis 19, wobei jedes längliche Substrat (101) mindestens einen elektrischen Pfad über einer Fläche des länglichen Substrats (101) aufweist, um einen elektrischen Kontakt auf einer Längskante des länglichen Substrats (101) mit einem elektrischen Kontakt gleicher Polarität auf der gegenüberliegenden Längskante des länglichen Substrats (101) zu verbinden, wobei der mindestens eine elektrische Pfad elektrisch isoliert gegenüber der Fläche des länglichen Substrats (101) ist.

21. Bauteil (100) nach Anspruch 20, wobei die Polarität der verbundenen elektrischen Kontakte n-leitend ist.

22. Bauteil (100) nach einem der Ansprüche 1 bis 21, das elektrische Pfade auf einer Fläche des Bauteils (100) aufweist, wobei die andere Fläche des Bauteils (100) im Wesentlichen gänzlich freigelegt und frei von elektrischen Verbindungen ist, um die Erzeugung von elektrischem Strom zu ermöglichen, wenn die besagte andere Fläche Licht ausgesetzt ist.

23. Bauteil (100) nach Anspruch 22, wobei die elektrischen Pfade im Wesentlichen rechtwinklig zu den Längskanten der länglichen Substrate (100) sind.

24. Bauteil (100) nach einem der Ansprüche 1 bis 23, wobei mindestens eine der gegenüberliegenden Flächen eines jeden länglichen Substrats (101) gänzlich freigelegt ist.

25. Bauteil (100) nach einem der Ansprüche 1 bis 24, wobei besagtes elektrisch leitfähiges Material Lötmetall aufweist.

26. Bauteil (100) nach einem der Ansprüche 1 bis 24, wobei besagtes elektrisch leitfähiges Material ein Polymer ist.

27. Bauteil (100) nach einem der Ansprüche 1 bis 26, wobei eine größte Abmessung des Bauteils (100) im Wesentlichen einem Durchmesser eines Standard-Halbleiter-Wafers entspricht.

28. Bauteil (100) nach einem der Ansprüche 1 bis 27, wobei die länglichen Substrate (101) durch ein Bandverfahren gebildet werden.

29. Bauteil (100) nach einem der Ansprüche 1 bis 27, wobei die länglichen Substrate (101) durch die Teilung von Halbleiter-Wafern in längliche Abschnitte gebildet werden, wobei die Flächen der länglichen Substrate aus entsprechenden Abschnitten einer Oberfläche eines jeden Halbleiter-Wafers gebildet werden.

30. Substrat-Bauteil (100) mit einer Vielzahl an Bauteilen (100) nach einem der Ansprüche 1 bis 29, wobei besagte Bauteile (100) gegenseitig befestigt und durch längliche Anschlüsse, die zwischen entsprechenden benachbarten Bauteilen der besagten Bauteile (100) angeordnet sind, elektrisch miteinander verbunden sind, wobei jeder der besagten länglichen Anschlüsse längslaufend parallel zu besagten Bauteilen (100) ist und lokalisierende Abschnitte aufweist, die gegenüberliegende Flächen eines jeden benachbarten länglichen Substrat(101)bauteils in Eingriff nehmen, wobei besagte Anschlüsse durch ein elektrisch leitfähiges Material, das zwischen besagten Anschlüssen und Längskanten der besagten länglichen Substrate (101) angeordnet ist, an besagten Bauteilen (100) angebracht und elektrisch damit verbunden sind.

31. Bauteil (100) nach Anspruch 30, wobei die lokalisierenden Abschnitte eines jeden länglichen Anschlusses erste lokalisierende Abschnitte aufweisen, die ein erstes benachbartes längliches Substrat-Bauteil in Eingriff nehmen, und zweite lokalisierende Abschnitte, die ein zweites benachbartes längliches Substrat-Bauteil (100) in Eingriff nehmen, wobei der längliche Anschluss einen spannungsentlastenden Abschnitt aufweist, der zwischen besagten ersten lokalisierenden Abschnitten und besagten zweiten lokalisierenden Abschnitten angeordnet ist, wobei besagter spannungsentlastender Abschnitt einen indirekten Pfad zwischen besagten lokalisierenden Abschnitten und besagten zweiten lokalisierenden Abschnitten definiert, um Wärmeausdehnung aufzunehmen und dadurch eine Verbindung zwischen den benachbarten länglichen Substrat-Bauteilen (100) aufrechtzuerhalten.

32. Substrat-Bauteil (100) nach einem der Ansprüche 30 oder 31, wobei die länglichen Anschlüsse aus Kupferfolie gebildet sind.

33. Bauteil (100) nach einem der Ansprüche 1 bis 32, mit einem Sammelschienenanschluss zum elektrischen Verbinden des besagten Bauteils mit einer Sammelschiene, wobei besagter Sammelschienenanschluss lokalisierende Abschnitte aufweist, die gegenüberliegende Flächen eines äußersten der besagten länglichen Substrate (101) in Eingriff nehmen, wobei besagter Sammelschienenanschluss an besagten Bauteilen (101) angebracht ist und elektrisch damit verbunden ist, durch ein elektrisch leitfähiges Material, das zwischen besagtem Sammelschienenanschluss und einer Längskante des besagten äußersten der besagten länglichen Substrate (101) angeordnet ist.

34. Bauteil (100) nach Anspruch 33, wobei besagter Sammelschienenanschluss einen Kontaktabschnitt aufweist, der sich weg von dem Substrat-Bauteil (100) erstreckt, das an besagtem Sammelschienenanschluss angebracht ist, um eine Verbindung zu besagter Sammelschiene zu ermöglichen.

35. Bauteil (100) nach Anspruch 34, wobei der Sammelschienenanschluss einen spannungsentlastenden Abschnitt (2001) aufweist, der einen indirekten Pfad zwischen besagtem Kontaktabschnitt und besagten lokalisierenden Abschnitten definiert, um Wärmeausdehnung aufzunehmen und dadurch eine elektrische Verbindung zwischen besagtem Bauteil (100) und besagter Sammelschiene aufrechtzuerhalten.

36. Solarenergiemodul mit einer Vielzahl an Substrat-Bauteilen (100) nach einem der Ansprüche 1 bis 35.

37. Photovoltaik-Vorrichtung mit einer Vielzahl an Substrat-Bauteilen (100) nach einem der Ansprüche 1 bis 35.

38. Linearer Konzentrator-Receiver mit einer Vielzahl an Substrat-Bauteilen (100) nach einem der Ansprüche 1 bis 35, wobei die Substrat-Bauteile (100) in einer oder mehreren Reihen angeordnet sind, wobei jede Reihe eine Vielzahl an besagten Substrat-Bauteilen (100), die im Wesentlichen aneinandergrenzen, aufweist.

39. Linearer Konzentrator-Receiver mit einer Vielzahl an Substrat-Bauteilen (100) nach einem der Ansprüche 1 bis 35, wobei die Substrat-Bauteile (100) in Reihen angeordnet sind, wobei jede Reihe eine Vielzahl an besagten Substrat-Bauteilen, die im Wesentlichen aneinandergrenzen und elektrisch in Reihe geschaltet sind, aufweist, wobei mindestens einige der Reihen elekrisch parallel geschaltet sind.

40. Linearer Konzentrator-Receiver nach einem der Ansprüche 38 oder 39, wobei die länglichen Substrate (101) elektrisch in Reihe geschaltet sind, so dass der von den länglichen Substraten (101) erzeugte elektrische Strom im Wesentlichen in eine Richtung parallel zu der Längsachse des linearen Konzentratorsystems fließt, um den Reihenwiderstand der länglichen Substrate (101) zu reduzieren.

41. Linearer Konzentrator-Receiver nach einem der Ansprüche 39 oder 40, wobei die Substrat-Bauteile (100) gewölbt sind, um Kosinusverluste im Receiver zu reduzieren.

42. Linearer Konzentrator-Receiver nach einem der Ansprüche 38 bis 41, wobei die Längskanten der Substrat-Bauteile (100) rechtwinklig zu einer Längsachse des linearen Konzentrator-Receivers sind.

43. Substrat-Bauteil-Verfahren, das das Ausbilden eines Substrat-Bauteils (100) für eine Photovoltaik-Vorrichtung durch Ablagerung eines elektrisch leitfähigen Materials (102; 202; 203; 301; 401; 502; 503; 601; 701) zwischen gegenüberliegenden Längskanten eines benachbarten länglichen Halbleiter-Substrats (101) aufweist, um besagte längliche Substrate (101) elektrisch miteinander zu verbinden und um besagte längliche Substrate (101) in einer längslaufend parallelen Anordnung zu halten, wobei das elektrisch leitfähige Material abgelagert wird, **dadurch gekennzeichnet, dass** gegenüberliegende Flächen eines jeden länglichen Substrats (101) zwischen dem elektrisch leitfähigen Material (102; 202; 203; 301; 401; 502; 503; 601; 701) im Wesentlichen gänzlich freigelegt bleiben.

44. Verfahren nach Anspruch 43, wobei mindestens eine der besagten gegenüberliegenden Flächen eines jeden länglichen Substrats (101) so angepasst ist, dass sie elektrischen Strom erzeugt, wenn sie Licht ausgesetzt ist.

45. Verfahren nach Anspruch 43, das die Ausbildung von Solarzellen in besagten länglichen Substraten (101) aufweist, so dass mindestens eine der besagten gegenüberliegenden Flächen so angepasst ist, dass sie elektrischen Strom erzeugt, wenn sie Licht ausgesetzt ist.

46. Verfahren nach Anspruch 45, wobei das elektrisch leitfähige Material so ausgewählt wird, dass es kompatibel mit einer Weiterverarbeitung zur Bildung von Solarzellen ist.

47. Verfahren nach einem der Ansprüche 43 bis 47, wobei die Längskanten der besagten länglichen Substrate (101) im Wesentlichen aneinander angrenzend gehalten werden.

48. Verfahren nach einem der Ansprüche 43 bis 47, wobei besagtes Bauteil im Wesentlichen flach ist.

49. Verfahren nach einem der Ansprüche 43 bis 47, wobei das Bauteil gewölbt ist.

50. Verfahren nach einem der Ansprüche 43 bis 49, das ein konformes Anbringen des Bauteils (100) an ein gewölbtes und im Wesentlichen steifes Auflager aufweist.

51. Verfahren nach einem der Ansprüche 43 bis 50, das ein Anordnen der besagten länglichen Substrate (101) zu einer gewölbten Anordnung, vor besagtem Ablagern, aufweist, wobei der Schritt des Ablagerns dazu führt, dass die gewölbte Anordnung im Wesentlichen flach wird.

52. Verfahren nach einem der Ansprüche 43 bis 51, das die Ausbildung einer AntiReflex- oder einer reflektierenden Beschichtung auf dem Bauteil (100) aufweist, nachdem das elektrisch leitfähige Material (102; 202; 203; 301; 401; 502; 503; 601; 701) abgelagert worden ist.

53. Verfahren nach einem der Ansprüche 43 bis 13; wobei das elektrisch leitfähige Material (102; 202; 203; 301; 401; 502; 503; 601; 701), das zwischen benachbarten länglichen Substraten (101) angeordnet ist, hervorstehende Abschnitte (701) aufweist, die sich über die Flächen der länglichen Substrate (101) hinaus erstrecken; wobei das Verfahren das Anbringen des Bauteils an ein Auflager oder einen Kühlkörper (903) an den hervorstehenden Abschnitten (701) aufweist.

54. Verfahren nach einem der Ansprüche 43 bis 53, das die Ausbildung von mindestens einem elektrischen Pfad über einer Fläche eines jeden länglichen Substrats (101) aufweist, um einen elektrischen Kontakt auf einer Längskante des länglichen Substrats (101) mit einem elektrischen Kontakt gleicher Polarität auf der gegenüberliegenden Längskante des länglichen Substrats (101) zu verbinden.

55. Verfahren nach einem der Ansprüche 43 bis 54, das die Ausbildung von elektrischen Anschlüssen auf einer Fläche des Bauteils (100) aufweist, wobei die andere Fläche des Bauteils (100) im Wesentlichen gänzlich freigelegt und frei von elektrischen Verbindunggen ist, um die Erzeugung von elektrischem Strom zu ermöglichen, wenn die besagte andere Fläche Licht ausgesetzt ist.

56. Verfahren nach Anspruch 55, das das Anbringen des Bauteils (100) auf einem Auflager mit einer Oberfläche mit Aussparungsbereichen darin aufweist, wobei die elektrischen Verbindungen auf der Fläche des Bauteils (100) in besagten Aussparungsbereichen aufgenommen sind.

57. Verfahren nach einem der Ansprüche 43 bis 56, wobei besagtes elektrisch leitfähiges Material (102; 202; 203; 301; 401; 502; 503; 601; 701) ein Polymer ist, so dass das Substrat-Bauteil (100) flexibel ist.

58. Verfahren nach einem der Ansprüche 43 bis 56, wobei das elektrisch leitfähige Material (102; 202; 203; 301; 401; 502; 503; 601; 701) durch ein Lötwellenverfahren abgelagert wird.

59. Verfahren nach einem der Ansprüche 43 bis 58, das das Anbringen von länglichen Anschlüssen zwischen entsprechenden benachbarten Substrat-Bauteilen aus einer Vielzahl von Substrat-Bauteilen (100) aufweist, die durch ein Verfahren gemäß den Ansprüchen 43 bis 58 gebildet wurden, wobei jeder der besagten länglichen Anschlüsse längslaufend parallel an besagten Bauteilen angebracht ist und lokalisierende Abschnitte aufweist, die gegenüberliegende Flächen eines jeden benachbarten länglichen Substrat(100)bauteils in Eingriff nehmen; und das das Einbringen eines elektrisch leitfähigen Materials (102; 202; 203; 301; 401; 502; 503; 601; 701) zwischen besagten Anschlüssen und Längskanten des besagten länglichen Substrats aufweist, zur mechanischen und elektrischen Verbindung besagter Bauteile (101).

60. Verfahren nach Anspruch 59, wobei das elektrisch leitfähige Material (102; 202; 203; 301; 401; 502; 503; 601; 701) zwischen die besagten Anschlüsse und die besagten Längskanten der besagten länglichen Substrate (101) unter Verwendung eines kontaklosen Lötverfahrens eingebracht wird.

61. Verfahren nach einem der Ansprüche 43 bis 60, das das Anbringen eines Sammelschienenanschlusses an ein Substrat-Bauteil (100) auweist, das durch ein Verfahren gemäß den Ansprüchen 43 bis 58 gebildet wurde, um besagtes Bauteil elektrisch mit einer Sammelschiene zu verbinden, wobei besagter Sammelschienenanschluss lokalisierende Abschnitte aufweist, die gegenüberliegende Flächen eines der äußersten der besagten länglichen Substrate (101) in Eingriff nehmen; und das das Einbringen eines elektrisch leitfähigen Materials (102; 202; 203; 301; 401; 502; 503; 601; 701) zwischen besagten Sammelschienenanschluss und einer Längskante des besagten länglichen Substrats (101) aufweist, um das besagte Bauteil mechanisch und elektrisch mit besagtem Sammelschienenanschluss zu verbinden.

62. Verfahren nach Anspruch 61, wobei das elektrisch leitfähige Material (102; 202; 203; 301; 401; 502; 503; 601; 701) zwischen besagten Sammelschienenanschluss und besagter Längskante des besagten länglichen Substrats (101) unter Verwendung eines kontaklosen Lötverfahrens eingebracht wird.

63. Verfahren nach einem der Ansprüche 43 bis 62, das das Ausbilden einer oder mehrerer Reihen von Substrat-Bauteilen (100) aufweist, die durch ein Verfahren gemäß den Ansprüchen 43 bis 58 gebildet wurden, wobei jede Reihe eine Vielzahl an besagten Substrat-Bauteilen (100), die im Wesentlichen aneinandergrenzen, aufweist; und das das Anbringen von besagter einer oder besagten mehreren Reihen in einem linearen Konzentrator-Receiver aufweist, so dass die Längskanten der Substrat-Bauteile (100) rechtwinklig zu einer Längsachse des linearen Konzentrator-Receivers sind.

64. Verfahren nach Anspruch 63, wobei eine Vielzahl an Reihen von besagten Bauteilen in besagtem linearen Konzentrator-Receiver angebracht sind, und wobei das Verfahren eine elektrische Parallel-Schaltung von mindestens einigen der Reihen aufweist.

65. Verfahren nach einem der Ansprüche 63 oder 64, das ein Wölben der Substrat-Bauteile (100) aufweist, um Kosinusverluste in dem linearen Konzentrator-Receiver zu reduzieren.

66. Substrat-Bauteil, das durch ein Verfahren gemäß einem der Ansprüche 43 bis 62 hergestellt wird.

67. Linearer Konzentrator-Receiver, der durch ein Verfahren gemäß einem der Ansprüche 63 bis 65 hergestellt wird.

68. Substrat-Bauteil-Gerät mit Bauelementen zur Ausführung der Schritte gemäß den Ansprüchen 43 bis 65.

## Revendications

1. Assemblage de substrat (100) pour un dispositif photovoltaïque, l'assemblage (100) comprenant un réseau de substrats semi-conducteurs allongés (101), chacun des substrats allongés (101) ayant des faces opposées (506) délimitées par des bords longitudinaux, les substrats allongés (101) étant électriquement interconnectés et maintenus dans un agencement longitudinalement parallèle par un matériau électriquement conducteur (102; 202; 203; 301; 401; 502; 503; 601; 701) disposé entre les bords longitudinaux opposés des substrats adjacents desdits substrats allongés (101), **caractérisé en ce que** les faces opposées de chaque substrat allongé (101) restent entièrement exposées entre le matériau électriquement conducteur (102; 202; 203; 301; 401; 502; 503; 601; 701).

2. Assemblage (100) selon la revendication 1, dans lequel lesdits substrats allongés (101) comprennent des cellules solaires de sorte qu'au moins l'une des faces opposées de chaque substrat allongé (101) est adaptée pour générer du courant électrique lorsqu'elle est exposée à la lumière.

3. Assemblage (100) selon la revendication 2, dans lequel les deux faces opposées de chaque substrat allongé sont adaptées pour générer du courant électrique lorsqu'elles sont exposées à la lumière.

4. Assemblage (100) selon la revendication 1, dans lequel le matériau électriquement conducteur (102; 202; 203; 301; 401; 502; 503; 601; 701) est sélectionné pour la compatibilité avec le traitement successif afin de former des cellules solaires dans lesdits substrats allongés.

5. Assemblage (100) selon l'une quelconque des revendications 1 à 4, dans lequel l'espacement entre les bords longitudinaux opposés desdits substrats allongés (101) est inférieur à environ 3 mm.

6. Assemblage (100) selon la revendication 5, dans lequel l'espacement entre les bords longitudinaux opposés desdits substrats allongés (101) est, au maximum, d'environ 3 µm.

7. Assemblage (100) selon l'une quelconque des revendications 1 à 6, dans lequel les bords longitudinaux opposés desdits substrats allongés (101) sont en butée sensible.

8. Assemblage (100) selon l'une quelconque des revendications 1 à 7, dans lequel l'assemblage (100) est sensiblement plan.

9. Assemblage (100) selon l'une quelconque des revendications 1 à 7, dans lequel l'assemblage (100) est incurvé.

10. Assemblage (100) selon la revendication 9, dans lequel l'assemblage (100) est monté de manière conforme sur un support incurvé et sensiblement rigide.

11. Assemblage (100) selon la revendication 10, dans lequel le support incurvé et sensiblement rigide est transparent.

12. Assemblage (100) selon l'une quelconque des revendications 1 à 7, dans lequel l'assemblage est flexible.

13. Assemblage (100) selon l'une quelconque des revendications 1 à 12, dans lequel les bords longitudinaux de chaque substrat allongé (101) comprennent un bord de type p (202; 502) et un bord de type n (203; 503), le matériau électriquement conducteur raccordant le bord de type p (202; 502) du substrat allongé (101) au bord de type n (203; 503) d'un substrat allongé (101) adjacent.

14. Assemblage (100) selon l'une quelconque des revendications 1 à 13, dans lequel le matériau électriquement conducteur disposé entre les substrats allongés (101) adjacents ne s'étend pas au-delà des faces des substrats allongés (101).

15. Assemblage (100) selon l'une quelconque des revendications 1 à 13, dans lequel le matériau électriquement conducteur disposé entre les substrats allongés (101) adjacents s'étend au-delà des faces des substrats allongés (101) pour permettre de fixer l'assemblage à un support ou un dissipateur de chaleur (903).

16. Assemblage (100) selon l'une quelconque des revendications 1 à 15, dans lequel le matériau électriquement conducteur est disposé sensiblement le long de la totalité de chaque bord longitudinal.

17. Assemblage (100) selon l'une quelconque des revendications 1 à 15, dans lequel le matériau électriquement conducteur est disposé à des emplacements mutuellement espacés le long de chaque bord longitudinal.

18. Assemblage (100) selon l'une quelconque des revendications 1 à 17, dans lequel chaque substrat allongé (101) comprend des contacts électriques sur ses bords longitudinaux, une partie de chaque contact électrique s'étendant partiellement sur une face du substrat allongé (101).

19. Assemblage (100) selon la revendication 18, dans lequel le matériau électriquement conducteur disposé entre les bords longitudinaux des substrats adjacents desdits substrats allongés (101) s'étend sur la partie d'extension de chaque contact électrique pour permettre de fixer l'assemblage à un support ou dissipateur de chaleur (903).

20. Assemblage (100) selon l'une quelconque des revendications 1 à 19, dans lequel chaque substrat allongé (101) comprend au moins une voie de passage électrique sur une face du substrat allongé (101) pour raccorder un contact électrique sur un bord longitudinal du substrat allongé (101) à un contact électrique de la même polarité sur le bord longitudinal opposé du substrat allongé (101), la au moins une voie de passage électrique étant électriquement isolée par rapport à la face du substrat allongé (101).

21. Assemblage (100) selon la revendication 20, dans lequel la polarité des contacts électriques raccordés est de type n.

22. Assemblage (100) selon l'une quelconque des revendications 1 à 21, comprenant des voies de passage électriques sur une face de l'assemblage (100), l'autre face de l'assemblage (100) étant exposée de manière sensiblement complète et dépourvue de raccordements électriques afin de faciliter la génération du courant électrique lorsque ladite autre face est exposée à la lumière.

23. Assemblage (100) selon la revendication 22, dans lequel les voies de passage électriques sont sensiblement orthogonales aux bords longitudinaux des substrats allongés (100).

24. Assemblage (100) selon l'une quelconque des revendications 1 à 23, dans lequel au moins l'une des faces opposées de chaque substrat allongé (101) est complètement exposée.

25. Assemblage (100) selon l'une quelconque des revendications 1 à 24, dans lequel ledit matériau électriquement conducteur comprend une brasure tendre.

26. Assemblage (100) selon l'une quelconque des revendications 1 à 24, dans lequel ledit matériau électriquement conducteur est un polymère.

27. Assemblage (100) selon l'une quelconque des revendications 1 à 26, dans lequel la dimension physique la plus grande de l'assemblage (100) est sensiblement égale à un diamètre d'une tranche de semi-conducteur standard.

28. Assemblage (100) selon l'une quelconque des revendications 1 à 27, dans lequel les substrats allongés (101) sont formés par le procédé Sliver.

29. Assemblage (100) selon l'une quelconque des revendications 1 à 27, dans lequel les substrats allongés (101) sont formés en divisant les tranches de semi-conducteur en parties allongées, les faces des substrats allongés étant formées à partir de parties correspondantes d'une surface de chaque tranche de semi-conducteur.

30. Assemblage de substrats (100) comprenant une pluralité d'assemblages (100) selon l'une quelconque des revendications 1 à 29, lesdits assemblages (100) étant mutuellement fixés et électriquement interconnectés par des connecteurs allongés disposés entre des assemblages adjacents correspondants desdits assemblages (100), chacun desdits connecteurs allongés étant longitudinalement parallèle auxdits assemblages (100) et ayant des parties de positionnement qui mettent en prise les faces opposées de chaque assemblage de substrats allongés (101) adjacents, lesdits connecteurs étant fixés et électriquement raccordés auxdits assemblages (100) par un matériau électriquement conducteur disposé entre lesdits connecteurs et les bords longitudinaux desdits substrats allongés (101).

31. Assemblage (100) selon la revendication 30, dans lequel les parties de positionnement de chaque connecteur allongé comprennent des premières parties de positionnement qui mettent en prise un premier assemblage de substrats allongés adjacents, et des secondes parties de positionnement qui mettent en prise un second assemblage de substrats allongés (100) adjacents, le connecteur allongé comprenant une partie de réduction de tension disposée entre lesdites premières parties de positionnement et lesdites secondes parties de positionnement, ladite partie de réduction de tension définissant une trajectoire indirecte entre lesdites parties de positionnement et lesdites secondes parties de positionnement pour accepter la dilatation thermique et ainsi maintenir le raccordement entre les assemblages de substrats allongés (100) adjacents.

32. Assemblage de substrats (100) selon la revendication 30 ou 31, dans lequel les connecteurs allongés sont formés à partir d'une feuille de cuivre.

33. Assemblage (100) selon l'une quelconque des revendications 1 à 32, comprenant un connecteur de barre omnibus pour raccorder électriquement ledit assemblage à une barre omnibus, ledit connecteur de barre omnibus comprenant des parties de positionnement qui mettent en prise les faces opposées du substrat situé le plus à l'extérieur desdits substrats allongés (101), ledit connecteur de barre omnibus étant fixé et électriquement raccordé auxdits assemblages (101) par un matériau électriquement conducteur disposé entre ledit connecteur de barre omnibus et un bord longitudinal dudit substrat situé le plus à l'extérieur desdits substrats allongés (101).

34. Assemblage (100) selon la revendication 33, dans lequel ledit connecteur de barre omnibus comprend une partie de contact s'étendant à distance dudit assemblage de substrats (100) fixé audit connecteur de barre omnibus afin de faciliter le raccordement à ladite barre omnibus.

35. Assemblage (100) selon la revendication 34, dans lequel le connecteur de barre omnibus comprend une partie de réduction de tension (2001) définissant une trajectoire indirecte entre ladite partie de contact et lesdites parties de positionnement pour accepter la dilatation thermique et maintenir ainsi le raccordement électrique entre ledit assemblage (100) et ladite barre omnibus.

36. Module d'énergie solaire comprenant une pluralité d'assemblages de substrats (100) selon l'une quelconque des revendications 1 à 35.

37. Dispositif photovoltaïque comprenant une pluralité d'assemblages de substrats (100) selon l'une quelconque des revendications 1 à 35.

38. Récepteur concentrateur linéaire comprenant une pluralité d'assemblages de substrats (100) selon l'une quelconque des revendications 1 à 35, les assemblages de substrats (100) étant agencés sur une ou plusieurs rangées, chaque rangée comprenant une pluralité desdits assemblages de substrats (100) en butée sensible.

39. Récepteur concentrateur linéaire comprenant une pluralité d'assemblages de substrats (100) selon l'une quelconque des revendications 1 à 35, les assemblages de substrats (100) étant agencés en rangées, chaque rangée comprenant une pluralité desdits assemblages de substrats en butée sensible et interconnectée électriquement en série, au moins certaines des rangées étant interconnectées électriquement en parallèle.

40. Récepteur concentrateur linéaire selon la revendication 38 ou 39, dans lequel les substrats allongés (101) sont électriquement raccordés en série de sorte que le courant électrique généré par les substrats allongés (101) s'écoule sensiblement dans une direction parallèle à l'axe longitudinal du système de concentrateur linéaire afin de réduire la résistance de série des substrats allongés (101).

41. Récepteur concentrateur linéaire selon la revendication 39 ou 40, dans lequel les assemblages de substrats (100) sont incurvés pour réduire les pertes en cosinus dans le récepteur.

42. Récepteur concentrateur linéaire selon l'une quelconque des revendications 38 à 41, dans lequel les bords longitudinaux des assemblages de substrats (100) sont orthogonaux à un axe longitudinal du récepteur concentrateur linéaire.

43. Procédé d'assemblage de substrats, comprenant l'étape consistant à former un assemblage de substrats (100) pour un dispositif photovoltaïque en déposant un matériau électriquement conducteur (102; 202; 203; 301; 401; 502; 503; 601; 701) entre des bords longitudinaux opposés des substrats semi-conducteurs allongés (101) adjacents pour interconnecter électriquement lesdits substrats allongés (101) et maintenir lesdits substrats allongés (101) dans un agencement longitudinalement parallèle, le matériau électriquement conducteur étant déposé, **caractérisé en ce que** les faces opposées de chaque substrat allongé (101) restent sensiblement complètement exposées entre le matériau électriquement conducteur (102; 202; 203; 301; 401; 502; 503; 601; 701).

44. Procédé selon la revendication 43, dans lequel au moins l'une desdites faces opposées de chaque substrat allongé (101) est adaptée pour générer du courant électrique lorsqu'elle est exposée à la lumière.

45. Procédé selon la revendication 43, comprenant l'étape consistant à former des cellules solaires dans lesdits substrats allongés (101) de sorte qu'au moins l'une desdites faces opposées est adaptée pour générer du courant électrique lorsqu'elle est exposée à la lumière.

46. Procédé selon la revendication 45, dans lequel le matériau électriquement conducteur est choisi pour la compatibilité avec un traitement successif afin de former lesdites cellules solaires.

47. Procédé selon l'une quelconque des revendications 43 à 47, dans lequel les bords longitudinaux desdits substrats allongés (101) sont maintenus en butée sensible.

48. Procédé selon l'une quelconque des revendications 43 à 47, dans lequel ledit assemblage est sensiblement plan.

49. Procédé selon l'une quelconque des revendications 43 à 47, dans lequel l'assemblage est incurvé.

50. Procédé selon l'une quelconque des revendications 43 à 49, comprenant l'étape consistant à monter de manière conforme l'assemblage (100) sur un support incurvé et sensiblement rigide.

51. Procédé selon l'une quelconque des revendications 43 à 50, comprenant l'étape consistant à agencer lesdits substrats allongés (101) dans un agencement incurvé avant ledit dépôt, l'étape de dépôt amenant l'agencement incurvé à devenir sensiblement plan.

52. Procédé selon l'une quelconque des revendications 43 à 51, comprenant l'étape consistant à former un revêtement anti-réflexion ou anti-réfléchissant sur l'assemblage (100) après que le matériau électriquement conducteur (102; 202; 203; 301; 401; 502; 503; 601; 701) a été déposé.

53. Procédé selon l'une quelconque des revendications 43 à 13, dans lequel le matériau électriquement conducteur (102; 202; 203; 301; 401; 502; 503; 601; 701) déposé entre les substrats allongés (101) adjacents comprend des parties en saillie (701) s'étendant au-delà des faces des substrats allongés (101); le procédé comprenant l'étape consistant à monter l'assemblage sur un support ou un dissipateur de chaleur (903) au niveau des parties en saillie (701).

54. Procédé selon l'une quelconque des revendications 43 à 53, comprenant l'étape consistant à former au moins une voie de passage électrique sur une face de chaque substrat allongé (101) pour raccorder un contact électrique sur un bord longitudinal du substrat allongé (101) à un contact électrique de la même polarité sur le bord longitudinal opposé du substrat allongé (101).

55. Procédé selon l'une quelconque des revendications 43 à 54, comprenant l'étape consistant à former des raccordements électriques sur une face de l'assemblage (100), l'autre face de l'assemblage (100) étant sensiblement complètement exposée et dépourvue de raccordements électriques afin de faciliter la génération du courant électrique lorsque ladite autre face est exposée à la lumière.

56. Procédé selon la revendication 55, comprenant l'étape consistant à monter l'assemblage (100) sur un support ayant une surface avec des régions évidées à l'intérieur de cette dernière, les raccordements électriques sur la face de l'assemblage (100) étant reçus dans lesdites régions évidées.

57. Procédé selon l'une quelconque des revendications 43 à 56, dans lequel ledit matériau électriquement conducteur (102; 202; 203; 301; 401; 502; 503; 601; 701) est un polymère de sorte que l'assemblage de substrats (100) est flexible.

58. Procédé selon l'une quelconque des revendications 43 à 56, dans lequel le matériau électriquement conducteur (102; 202; 203; 301; 401; 502; 503; 601; 701) est déposé par un procédé d'onde de brasure tendre.

59. Procédé selon l'une quelconque des revendications 43 à 58, comprenant l'étape consistant à fixer les connecteurs allongés entre les assemblages adjacents correspondants d'une pluralité d'assemblages de substrats (100) formés par un procédé selon l'une quelconque des revendications 43 à 58, chacun desdits connecteurs allongés étant fixé de manière longitudinalement parallèle auxdits assemblages et ayant des parties de positionnement qui mettent en prise les faces opposées de chaque assemblage de substrats allongés (100) adjacents; et l'étape consistant à introduire un matériau électriquement conducteur (102; 202; 203; 301; 401; 502; 503; 601; 701) entre lesdits connecteurs et les bords longitudinaux desdits substrats allongés pour interconnecter mécaniquement et électriquement lesdits assemblages (101).

60. Procédé selon la revendication 59, dans lequel le matériau électriquement conducteur (102; 202; 203; 301; 401; 502; 503; 601; 701) est introduit entre lesdits connecteurs et lesdits bords longitudinaux desdits substrats allongés (101) en utilisant un procédé de brasure tendre sans contact.

61. Procédé selon l'une quelconque des revendications 43 à 60, comprenant l'étape consistant à fixer un connecteur de barre omnibus sur un assemblage de substrats (100) formé par un procédé selon l'une quelconque des revendications 43 à 58, pour raccorder électriquement ledit assemblage à une barre omnibus, ledit connecteur de barre omnibus comprenant des parties de positionnement qui mettent en prise des faces opposées du substrat situé le plus à l'extérieur desdits substrats allongés (101); et l'étape consistant à introduire un matériau électriquement conducteur (102; 202; 203; 301; 401; 502; 503; 601; 701) entre ledit connecteur de barre omnibus et un bord longitudinal dudit substrat allongé (101) pour interconnecter mécaniquement et électriquement ledit assemblage audit connecteur de barre omnibus.

62. Procédé selon la revendication 61, dans lequel le matériau électriquement conducteur (102; 202; 203; 301; 401; 502; 503; 601; 701) est introduit entre ledit connecteur de barre omnibus et ledit bord longitudinal dudit substrat allongé (101) en utilisant un procédé de brasure tendre sans contact.

63. Procédé selon l'une quelconque des revendications 43 à 62, comprenant l'étape consistant à former une ou plusieurs rangées d'assemblages de substrats (100) formés par un procédé selon l'une quelconque des revendications 43 à 58, chaque rangée comprenant une pluralité desdits assemblages de substrats (100) en butée sensible; et l'étape consistant à monter lesdites une ou plusieurs rangées dans un récepteur concentrateur linéaire de sorte que les bords longitudinaux des assemblages de substrats (100) sont orthogonaux par rapport à un axe longitudinal du récepteur concentrateur linéaire.

64. Procédé selon la revendication 63, dans lequel une pluralité de rangées desdits assemblages sont montées dans ledit récepteur concentrateur linéaire, et le procédé comprend l'étape consistant à interconnecter électriquement au moins certaines des rangées en parallèle.

65. Procédé selon la revendication 63 ou 64, comprenant l'étape consistant à incurver les assemblages de substrats (100) pour réduire les pertes en cosinus dans le récepteur concentrateur linéaire.

66. Assemblage de substrats produit par un procédé selon l'une quelconque des revendications 43 à 62.

67. Récepteur concentrateur linéaire produit par un procédé selon l'une quelconque des revendications 63 à 65.

68. Appareil d'assemblage de substrats ayant des composants pour exécuter les étapes selon l'une quelconque des revendications 43 à 65.
